# EUROPEAN PATENT APPLICATION

(11) **EP 4 418 836 A1**
(43) Date of publication of application: **21.08.2024**
(21) Application number: 23787534.9
(22) Date of filing: 31.03.2023
(51) Int. Cl.: H10K 59/00

(54) **LIGHT-EMITTING ELEMENT**

(30) Priority: 13.04.2022 CN 202210387862
(71) Applicant: Taizhou Guanyu Technology Co., Ltd., Taizhou, Zhejiang 318057 (CN)
(72) Inventor: CHEN, Huei-siou, Datong, Taipei City 103 (TW); WEI, Li-chen, Taichung City 406 (TW); HSU, Kuo-cheng, Taichung City 406 (TW); CHU, Ker Tai, Taipei City 11494 (TW)
(74) Representative: Michalski Hüttermann & Partner Patentanwälte mbB
(86) International application number: PCT/CN2023/085457
(87) International publication number: WO 2023/197889

(57) **Abstract**

A light-emitting component includes a substrate and a protective layer. A plurality of bumps is disposed above the substrate and between the substrate and the protective layer, wherein the plurality of bumps include two adjacent bumps, and an organic light-emitting unit including an organic material is disposed between the two adjacent bumps. At least one of the plurality of bumps includes a surface facing away from the substrate, the surface includes a corrugated portion, and the corrugated portion includes a vertex facing the substrate. The light-emitting component also includes an optical absorption unit, which is disposed between the substrate and the protective layer.

## Description

### BACKGROUND OF THE PRESENT DISCLOSURE

### FIELD OF THE PRESENT DISCLOSURE

The present disclosure relates to a light-emitting element and, in particular, to an organic light-emitting element.

### DESCRIPTION OF THE PRIOR ART

Organic light-emitting displays have been widely used in the most high-end electronic apparatuses. However, due to limitations of existing technology, the luminous efficiency and quality of light-emitting materials cannot be effectively controlled, resulting in the optical effects of the device not being as good as expected.

### SUMMARY OF THE PRESENT DISCLOSURE

In the present disclosure, a light-emitting component is provided. The light-emitting component includes a substrate and a protective layer. A plurality of bumps is disposed above the substrate and between the substrate and the protective layer, wherein the plurality of bumps include two adjacent bumps, and an organic light-emitting unit including an organic material is disposed between the two adjacent bumps. At least one of the plurality of bumps includes a surface facing away from the substrate, the surface includes a corrugated portion, and the corrugated portion includes a vertex facing the substrate. The light-emitting component also includes an optical absorption unit, which is disposed between the substrate and the protective layer.

In the present disclosure, there is a light-emitting component, which includes a substrate, and a plurality of organic light-emitting units are above the substrate, wherein the organic light-emitting units include a first light-emitting unit and a second light-emitting unit, each of which has an organic light-emitting stack layer including an organic material and emits light with different colors, wherein a total thickness of the organic light-emitting stack layer of the first light-emitting unit is greater than a total thickness of the organic light-emitting stack layer of the second light-emitting unit.

In the present disclosure, there is also a manufacturing method of a light-emitting component, which includes providing a substrate and forming a plurality of bumps on the substrate. The manufacturing method also includes forming a photosensitive layer on the plurality of bumps and patterning the photosensitive layer to form a trench through the photosensitive layer to expose a surface. The manufacturing method also includes disposing an organic material on the surface and removing the patterned photosensitive layer, and continuously overlaying a dielectric layer over the plurality of bumps, wherein at least one bump among the plurality of bumps includes a surface facing away from the substrate, the surface includes a corrugated portion, and the corrugated portion includes a vertex facing the substrate.

In some embodiments, an absorption rate of the bump for a specific wavelength is greater than or equal to 60% and the specific wavelength is not greater than 400 nm.

In some embodiments, an absorption rate of the protective layer for a specific wavelength is greater than or equal to 60%, and the specific wavelength is not greater than 400 nm.

In some embodiments, an absorption rate of the organic material for a specific wavelength is greater than or equal to 60% and the specific wavelength is not greater than 400 nm.

In some embodiments, an absorption rate of the photosensitive layer for a specific wavelength is greater than or equal to 30% and the specific wavelength is not greater than 400 nm.

In some embodiments, the organic material is disposed in an organic layer, and the organic layer is one of an electron transport layer (ETL), an electron injection layer (EIL), an emissive layer (EM), a hole blocking layer (HBL), a hole injection layer (HIL), or a hole transport layer (HTL).

In some embodiments, an absorption rate of the optical absorption unit for a specific wavelength is greater than or equal to 60% and the specific wavelength is not greater than 400 nm.

In some embodiments, each of the organic light-emitting units has an effective light-emitting region with a size equal to a total area of an anode located under each of the light-emitting units, and each of the light-emitting units has a black region and a bright region when emitting light, wherein a total area of the black region is less than 50% of the effective light-emitting region.

### BRIEF DESCRIPTION OF THE DRAWINGS

FIG. 1 is a top view illustrating an intermediate product of a light-emitting element.
FIG. 2A is an illustrative cross-sectional view along line AA in FIG. 1.
FIG. 2B is a schematic view illustrating a bump falling on two adjacent first electrodes.
FIG. 2C is a schematic view illustrating another embodiment of the bump.
FIG. 3 is a cross-sectional view of an embodiment.
FIG. 4A is a top view illustrating a portion of a light-emitting layer having several light-emitting pixels.
FIG. 4B is a top view illustrating a portion of a light-emitting layer having several light-emitting pixels.

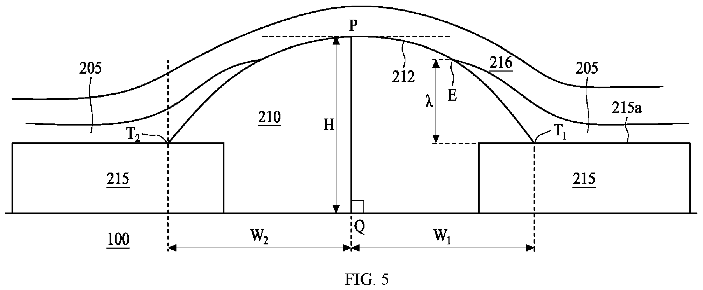

FIG. 5 is a cross-sectional view of an embodiment.
FIG. 6A illustrates a cross-sectional view of an electrode.
FIG. 6B illustrates a cross-sectional view of an electrode.
FIG. 6C illustrates a cross-sectional view of an electrode.
FIG. 7A is a cross-sectional view of an embodiment.
FIG. 7B is a cross-sectional view of an embodiment.
FIG. 8 is a cross-sectional view of a light-emitting element according to an embodiment.
FIG. 9 is a top view of a light-emitting element according to an embodiment.
FIG. 10 is a cross-sectional view of a light-emitting element according to an embodiment.
FIG. 11 is a cross-sectional view of a light-emitting element according to an embodiment.
FIG. 12 is a cross-sectional view of a light-emitting element according to an embodiment.
FIG. 13 is a cross-sectional view of a light-emitting element according to an embodiment.
FIG. 14 is a cross-sectional view of a light-emitting element according to an embodiment.
FIG. 15 is a cross-sectional view of a light-emitting element according to an embodiment.
FIG. 15A to FIG. 15F illustrate a method of manufacturing a light-emitting element according to an embodiment.
FIG. 16A to FIG. 16G illustrate a method of manufacturing a light-emitting element according to an embodiment.
FIG. 17A is a cross-sectional view illustrating a portion of a light-emitting element according to an embodiment.
FIG. 17B is a cross-sectional view illustrating a portion of a light-emitting element according to an embodiment.
FIG. 18 is a cross-sectional view illustrating an embodiment of a bump according to an embodiment.
FIG. 19 is a top view illustrating an organic light-emitting unit according to an embodiment.
FIG. 20 is a top view illustrating an organic light-emitting unit according to an embodiment.

### DETAILED DESCRIPTION OF THE EMBODIMENTS

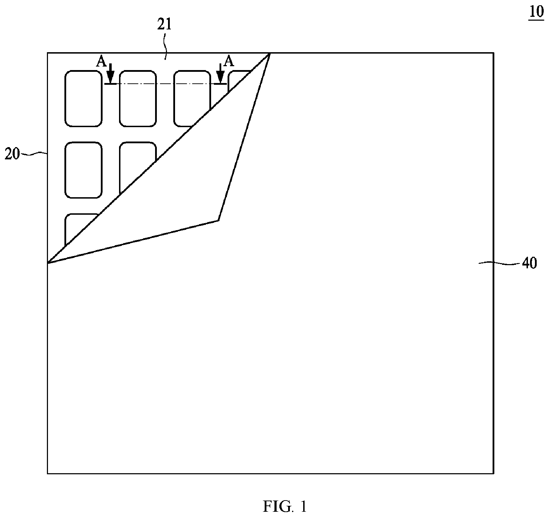

FIG. 1 is a top view illustrating an intermediate product of the light-emitting element 10. The light-emitting element 10 has a light-emitting layer and a capping layer 40 located above the light-emitting layer 20. For the light-emitting layer 20, the spacers 21 may be designed to provide an array of recesses for accommodating the array of light-emitting pixels. In some embodiments, the spacers 21 may include a photosensitive material.

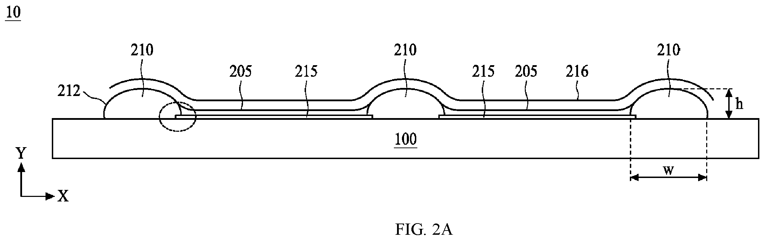

FIG. 2A is an illustration of a cross-sectional view taken along line AA in FIG. 1 and illustrates the light emitting area only. For simplicity, the capping layer 40 is omitted here. The spacer 21 has a plurality of bumps 210 to define a light-emitting pixel pattern. A recess is located between two adjacent bumps 210 and provides a space for accommodating a light-emitting pixel. Those skilled in the art should understand that the bumps 210 are shown disconnected when viewed in cross-section, but they may be connected to each other via other parts of the spacer 21 when viewed from the top view of FIG. 1.

In some embodiments, the absorption rate of the bump 210 for a specific wavelength is greater than or equal to 50%. In some embodiments, the absorption rate of the bump 210 for a specific wavelength is greater than or equal to 60%. In some embodiments, the absorption rate of the bump 210 for a specific wavelength is greater than or equal to 70%. In some embodiments, the absorption rate of the bump 210 for a specific wavelength is greater than or equal to 80%. In some embodiments, the absorption rate of the bump 210 for a specific wavelength is greater than or equal to 90%. In some embodiments, the absorption rate of the bump 210 for a specific wavelength is greater than or equal to 95%. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm.

In an embodiment, the light-emitting unit 260 includes a first electrode 215, a first carrier transport layer 262 above the bump 210 and the first electrode 215, a second carrier transport layer 263 above a portion of the first carrier transport layer 262, and an organic emissive layer 264 above the second carrier transport layer 263. In some embodiments, a carrier injection layer 261 is disposed between the first electrode 215 and the first carrier transport layer 262. The light-emitting unit 260 includes an organic material, which can be placed in any layer of the carrier transport layer, the carrier injection layer or the organic emissive layer in the light-emitting unit 260 according to different embodiments. Further, in some embodiments, the absorption rate of the organic material for a specific wavelength is greater than or equal to 50%. In some embodiments, the absorption rate of the organic material for a specific wavelength is greater than or equal to 60%. In some embodiments, the absorption rate of the organic material for a specific wavelength is greater than or equal to 70%. In some embodiments, the absorption rate of the organic material for a specific wavelength is greater than or equal to 80%. In some embodiments, the absorption rate of the organic material for a specific wavelength is greater than or equal to 90%. In some embodiments, the absorption rate of the organic material for a specific wavelength is greater than or equal to 95%. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm.

The substrate 100 is located below the light-emitting layer 20. In some embodiments, the substrate 100 may include a transistor array configured to correspond to the light-emitting pixels in the light-emitting layer 20. The substrate 100 may include several capacitors. In some embodiments, more than one transistor is configured to form a circuit with a capacitor and a light-emitting pixel.

In some embodiments, an optical absorption unit is included between the substrate 100 and the capping layer 40. The absorption rate of the optical absorption unit for a specific wavelength is greater than or equal to 50%. In some embodiments, the absorption rate of the optical absorption unit for a specific wavelength is greater than or equal to 60%. In some embodiments, the absorption rate of the optical absorption unit for a specific wavelength is greater than or equal to 70%. In some embodiments, the absorption rate of the optical absorption unit for a specific wavelength is greater than or equal to 80%. In some embodiments, the absorption rate of the optical absorption unit for a specific wavelength is greater than or equal to 90%. In some embodiments, the absorption rate of the optical absorption unit for a specific wavelength is greater than or equal to 95%. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm.

In some embodiments, the substrate 100 is a stack including at least three different layers. The substrate 100 may have an inorganic dielectric layer located at the bottom and a metal layer on the inorganic dielectric layer. Another inorganic dielectric layer is located above the metal layer. The metal layer is sandwiched between two inorganic dielectric layers. In some embodiments, the inorganic dielectric layer may be replaced with an organic dielectric layer having a bend radius of less than about 100 microns. In some embodiments, the inorganic dielectric layer has a thickness of between about 400 microns and 1,200 microns. The metal layer has a thickness of about 100 microns to 400 microns. In some embodiments, substrate 100 includes two polymer layers and an inorganic layer between the two polymer layers.

In some embodiments, the substrate 100 has two polymer layers and a metal layer between the two polymer layers. In some embodiments, the substrate 100 has two polymer layers and an inorganic layer between the two polymer layers. The inorganic layer may include an oxide or a nitride. In some embodiments, the inorganic layer includes silicon oxide, silicon nitride, or aluminum oxide. In some embodiments, the inorganic layer is more water-resistant than the polymer layer. In some embodiments, at least one side (along the film stacking direction) of the polymer layer is coated with an inorganic layer. In some embodiments, the polymer layer has a thickness of between about 1 micron and about 5 microns. In some embodiments, the substrate 100 is partially formed of a black material. The black material can absorb visible light to reduce reflections.

The light-emitting pixel has a first electrode 215 located above the substrate 100. In some examples, the first electrode 215 is an anode of a light-emitting pixel. The first electrode 215 is partially covered by the spacer 21. As shown in FIG. 2A, the peripheral area of the first electrode 215 is covered by the bumps 210. In some embodiments, the edge corners of the first electrode 215 are completely surrounded by the bumps 210. In some embodiments, the sidewalls of the first electrode 215 are completely contacted with the bump 210.

The first electrode 215 may have a total thickness of about 1,500 Å to about 2,700 Å. In some embodiments, the first electrode 215 has a total thickness of about 1,800 Å to about 2,200 Å. In some embodiments, the first electrode 215 has a total thickness of approximately 2,000 Å. The first electrode 215 may include ITO, IZO, AlCu alloy, AgMo alloy, about 50 Å to 500 Å ITO (or IZO) and 500 Å to 2,000 Å metal film (Ag, Al, Mg, Au) and about 50 Å to 1,000 Å ITO (or IZO).

The second electrode 216 is located above the light-emitting material 205. In some cases, the second electrode 216 is patterned to cover only the effective light-emitting region of each light-emitting pixel. In some cases, the second electrode 216 is in contact with the light-emitting material 205. The second electrode 216 may be a continuous film as shown in FIG. 2A and is located above the light-emitting material 205 and the bump 210. In other words, the second electrode 216 is a common electrode of several light-emitting pixels. In some cases, the second electrode 216 is a common electrode for all light-emitting pixels in the light-emitting layer 20.

The second electrode 216 may have a thickness of about 80 Å to about 500 Å. In some embodiments, the second electrode 216 may have a thickness of about 80 Å to about 150 Å. In some embodiments, the second electrode 216 may have a thickness of about 150 Å to about 200 Å. In some embodiments, the second electrode 216 may have a thickness of about 200 Å to about 300 Å. In some embodiments, the second electrode 216 may have a thickness of about 300 Å to about 400 Å. In some embodiments, the second electrode 216 may have a thickness of about 400 Å to about 500 Å. In some embodiments, the second electrode 216 is a composite structure. For example, the second electrode 216 has a conductive film and a transparent conductive film thereon. The conductive film is located between the transparent conductive film and the light-emitting material 205. In some embodiments, the conductive film includes aluminum, gold, silver, copper, magnesium, molybdenum, etc. In some embodiments, the transparent conductive film includes indium, tin, graphene, zinc, oxygen, etc. In some embodiments, the transparent conductive film is ITO (indium tin oxide). In some embodiments, the transparent conductive film is IZO (indium zinc oxide). In some embodiments, a transparent conductive film is located between the conductive film and the light-emitting material 205.

The light-emitting material 205 is located between the first electrode 215 and the second electrode 216. In some embodiments, the light-emitting material 205 is a composite film structure having several films stacked along a vertical direction (Y-axis). The light-emitting material 205 may have several carrier transport or injection films. The light-emitting material 205 may have an emitting layer (EL). The carrier may be a hole or an electron.

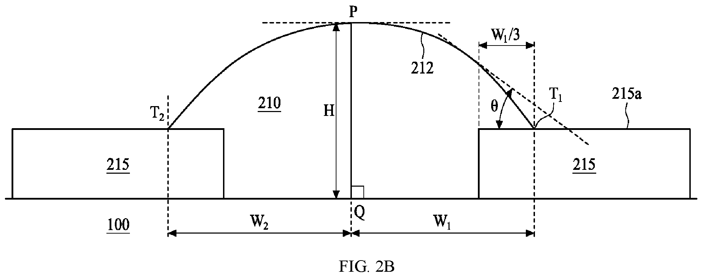

In some embodiments, the bump 210 has a curved surface 212 protruding from the substrate 100 and a portion of light-emitting material 205 (referring to the dashed circle) is located above the curved surface 212. FIG. 2B illustrates the bump 210 falling on two adjacent first electrodes 215. The bump 210 has a peak P, and the thickness H of the bump is the maximum thickness at the peak P. In this disclosure, the thickness is measured along the Y-axis. Regarding the bump 210, the thickness is measured from the interface (or point Q) between the substrate 100 and the bump 210. In some embodiments, the thickness H of the bump 210 at the peak P is about 7,000 Å to about 10,000 Å. In some embodiments, thickness H is about 7,000 Å to about 8,000 Å. In some embodiments, the thickness H of the bump 210 is about 8,000 Å to about 9,000 Å. In some embodiments, the thickness H of the bump 210 is about 9,000 Å to about 10,000 Å. H is the shortest distance between the peak P and point Q. In some embodiments, the thickness H is approximately 1.5 to 2 times greater than the total thickness of the first electrode 215.

Line PQ is the centerline of the bump 210. The curved surface 212 intersects the first electrode 215 at point Tₓ. T₁ is the right intersection point, and T₂ is the left intersection point. W₁ is the distance between the intersection point T₁ and the line PQ, and W₂ is the distance between the intersection point T₂ and the line PQ. In some embodiments, W₁ is between about 0.8 microns and about 1.6 microns. In some embodiments, W₁ is between about 0.8 microns and about 1.0 microns. In some embodiments, W₁ is between about 1.0 micron and about 1.2 micron. In some embodiments, W₁ is between about 1.2 microns and about 1.4 microns. In some embodiments, W₁ is between about 1.4 microns and about 1.6 microns. In some embodiments, W₁ is substantially equal to W₂. In some embodiments, the difference between W₁ and W₂ is greater than 8%, that is, the bump 210 falls asymmetrically on the adjacent first electrodes.

Another feature of the bump 210 is the angle θ between the curved surface 212 and the first electrode 215. To measure the angle θ, first, a tangent line on the curved surface 212 is drawn at a point 1/3 W₁ away from the intersection point T₁. The tangent line extends to intersect a surface 215a of the first electrode 215. θ is the angle between the tangent line and the surface 215a. In some embodiments, the angle is between about 35 and 55 degrees. In some embodiments, the angle is between about 35 and 45 degrees. In some embodiments, the angle is between about 40 and 45 degrees. In some embodiments, the angle is between about 45 and 50 degrees. In some embodiments, the angle is between about 50 and 55 degrees. In some embodiments, the angle is between about 40 and 55 degrees.

In some embodiments, the bumps 210 of the spacer may have fluorine (F). In the bump 210, the region close to the curved surface 212 has a greater F concentration than other regions. In some embodiments, some metal oxide particles may be added to the bumps 210. These particles can serve to scatter the light emitted from the light-emitting material 205.

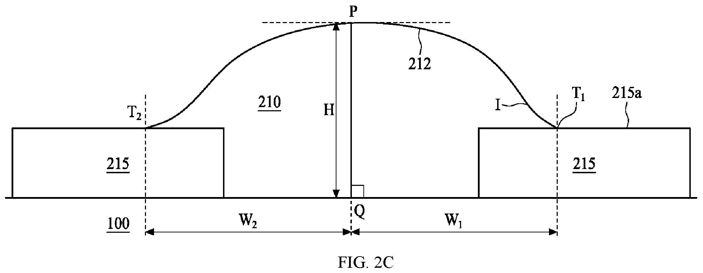

FIG. 2C shows another embodiment of the bump 210. The curved surface 212 has an inflection point I close to the intersection point T₁. The curved surface 212 protrudes from the substrate 100 between point P and point I. Beyond the inflection point I, the curved surface 212 is concave toward the substrate 100. In some embodiments, the inflection point I is located approximately 1/6 W₁ from the intersection point T₁. In some embodiments, the inflection point I is located approximately 1/7 W₁ from the intersection point T₁. In some embodiments, the inflection point I is located approximately 1/8 W₁ from the intersection point T₁.

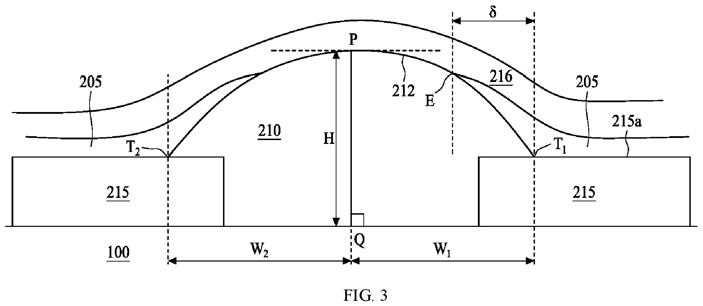

Referring to FIG. 3, the light-emitting material 205 is continuously lined along the first electrode 215 and further extends to partially cover the curved surface 212 before ending at point E. In other words, point E is the intersection point of the bump 210, the second electrode 216 and the light-emitting material 205.

The light-emitting material 205 has a portion overlapping the first electrode. In some embodiments, the portion is also called an effective illumination area. In some embodiments, the effective illumination area has a width of at least less than 10 microns. In some embodiments, the effective illumination area has a width of about 3 microns to 6 microns. In some embodiments, the effective illumination area has a width of about 4 microns to 6 microns. The effective illumination area determines the pixel size of the light-emitting element 10 in FIG. 1. Since the size of the effective illumination area can be controlled below 10 microns, the pixel density of the light-emitting element 10 can be more than 1,000 or 2,000 ppi.

The horizontal distance δ is the distance from the intersection point T₁ to the end point E along the X-axis. The horizontal distance δ represents how the light-emitting material 205 overlaps the bump 210. The horizontal distance δ is also called the overlap width. In some embodiments, the overlap width δ is approximately 80-85% of W₁. In some embodiments, the overlap width δ is approximately 75-80% of W₁. In some embodiments, the overlap width δ is approximately 75-90% of W₁. In some embodiments, the overlap width δ is between about 0.85 microns and 1.0 microns. In some embodiments, the overlap width δ is between about 0.8 microns and 0.9 microns. In some embodiments, the overlap width δ is between about 0.9 microns and 1.0 microns.

In some embodiments, there are two different types of light-emitting pixels in the light-emitting element 10. The first type of pixel emits light having a first wavelength spectrum, and the second type of pixel emits light having a second wavelength spectrum that is different from the first wavelength spectrum. In some embodiments, the first type of pixel has a larger overlap width than the second type of pixel. In some embodiments, the overlap width of the first type of pixel is approximately 0.1% greater than the overlap width of the second type of pixel. In some embodiments, the overlap width of the first type of pixel is approximately 60% greater than the overlap width of the second type of pixel. In some embodiments, the overlap width of the first type of pixel is about 0.1% to about 60% greater than the overlap width of the second type of pixel.

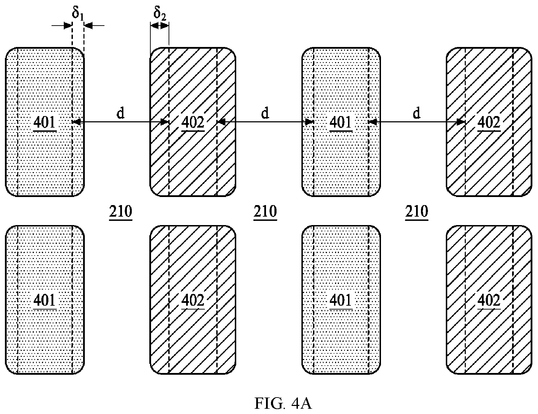

FIG. 4A is a top view illustrating a portion of the light-emitting layer 20 having several light-emitting pixels. The first type of pixel is numbered 401, and the second type of pixel is numbered 402. The dashed lines represent where the light-emitting material of each pixel meets the bump 210. The dashed line in FIG. 4A indicates where point T₁ or T₂ in FIG. 3 is located. The spacing d is the width of the bump 210 in FIG. 3, that is, d=W₁+W₂. All the bumps have a substantial width. However, the overlap widths are different. The overlap width of the first type of pixel is δ₁, and the overlap width of the second type of pixel is δz; and δ₁ is less than δz. Therefore, although the bumps in the light-emitting layer 20 may have a uniform width, if adjacent pixels are of different types (emitting different wavelength spectra), they have different overlap widths.

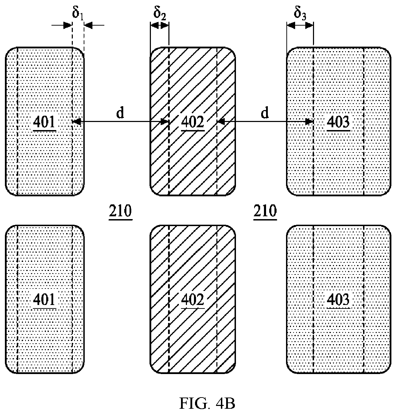

FIG. 4B is a top view illustrating a portion of the light-emitting layer 20 having several light-emitting pixels. The first type of pixel is numbered 401, the second type of pixel is numbered 402, and the third type of pixel is numbered 403. The dashed lines represent where the light-emitting material of each pixel meets the bump 210. The dashed line in FIG. 4B indicates where point T₁ or T₂ in FIG. 3 is located. The spacing d is the width of the bump 210 in FIG. 3, that is, d=W₁+W₂. All the bumps have a substantial width. However, the overlap widths are different. The overlap width of the first type of pixel is δ₁, the overlap width of the second type of pixel is δz, and the overlap width of the third type of pixel is δ₃. δ₁ is less than δ₂, and δ₂ is less than δ₃. Similar to FIG. 4A, the bumps in the light-emitting layer 20 have a uniform width, and if adjacent pixels are of different types (emitting different wavelength spectra), they have different overlap widths. In some embodiments, δ₁ is less than δz by about 0.1% to about 60%, and δz is less than δ₃ by about 0.1% to about 60%.

The vertical distance λ is the distance from the intersection point T₁ to the end point E measured along the Y-axis. The vertical distance λ may also be used to indicate how the light-emitting material 205 overlaps or covers the bump 210. The vertical distance λ is also called the overlap height. In some embodiments, the overlap height λ is approximately 60-80% of H. In some embodiments, the overlap height λ is approximately 60-75% of H. In some embodiments, the overlap height λ is approximately 65-75% of H. In some embodiments, the overlap height λ is about 70-80% of H. In some embodiments, the overlap height λ is about 70-75% of H. In some embodiments, the overlap height λ is approximately 60-75% of H. In some embodiments, the overlap height λ is approximately 75-80% of H.

In some embodiments, the overlap height λ is approximately 0.6 microns to 0.8 microns. In some embodiments, the overlap height λ is approximately 0.65 microns to 0.7 microns. In some embodiments, the overlap height λ is approximately 0.7 microns to 0.75 microns. In some embodiments, the overlap height λ is approximately 0.75 microns to 0.8 microns.

In some embodiments, the first type of pixel has a greater overlap height than the second type of pixel. In some embodiments, the overlap height of the first type of pixel is about 20% to about 50% greater than the overlap height of the second type of pixel. In some embodiments, the overlap height of the first type of pixel is greater than the overlap height of the second type of pixel, and the overlap height of the second type of pixel is greater than the overlap height of the third type of pixel. In some embodiments, the overlap height of the first type of pixel is about 20% to about 50% greater than the overlap height of the second type of pixel. In some embodiments, the overlap height of the second type of pixel is about 20% to about 50% greater than the overlap height of the third type of pixel.

In some cases, light-emitting material 205 is in contact with the curved surface 212. The portion of the light-emitting material 205 in contact with the curved surface 212 is conformal to the curved surface 212.

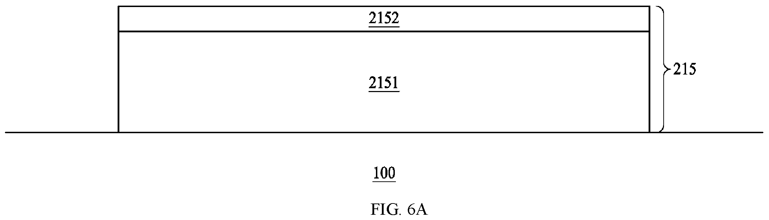

In some embodiments, the electrode 215 has a composite structure. For example, the electrode 215 has a conductive film and a transparent conductive film located thereon. FIG. 6A is an example of the electrode 215. The conductive film 2151 is located between the transparent conductive film 2152 and the substrate 100. In some embodiments, the conductive film 2151 includes aluminum, gold, silver, copper, etc. In some embodiments, transparent conductive film 2152 includes indium, tin, graphene, zinc, oxygen, etc. In some embodiments, the transparent conductive film 2152 is ITO (indium tin oxide). In some embodiments, the transparent conductive film 2152 is IZO (Indium Zinc Oxide). The thickness of the metal film 2151 may be between about 1,500 Å and about 3,000 Å. The thickness of the transparent conductive film 2152 may be between about 80 Å and about 1,000 Å.

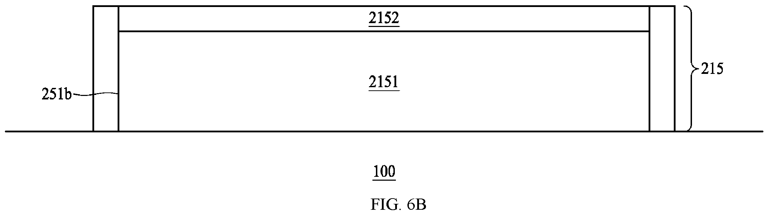

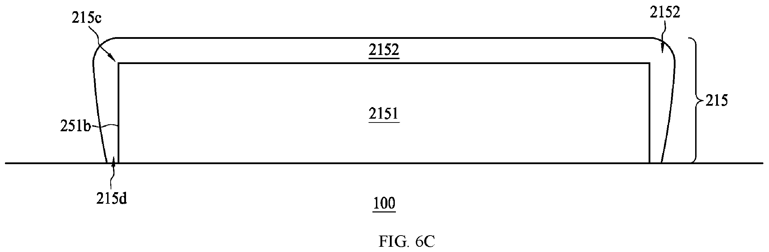

In some embodiments, the transparent conductive film 2152 further extends to cover the sidewalls 215b of the conductive layer 2151, as shown in FIG. 6B. In some embodiments, along the sidewall 215b, the transparent conductive film 2152 has a maximum thickness at the topmost portion 215c of the sidewall 215b and a lowest portion located at the bottommost portion 215d of the sidewall (where the transparent conductive film 2152 meets the substrate 100), as shown in FIG. 6C. In some embodiments, the thickness of the transparent conductive film 2152 increases with a gradient relative to the vertical distance between the transparent conductive film 2152 and the substrate 100.

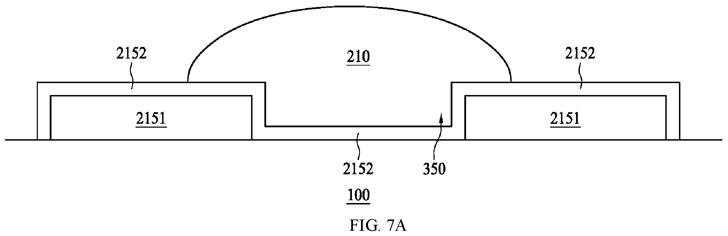

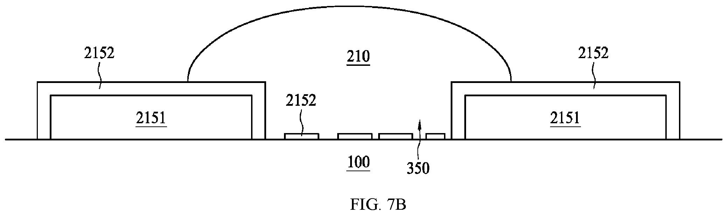

In some embodiments, the transparent conductive film 2152 further extends to a valley 350 between two adjacent but separate conductive layers, as shown in FIG. 7A. The bumps 210 fill the valley. In the valley 350, one side of the transparent conductive film 2152 contacts the substrate 100 and the opposite side contacts the bump 210. The conductive film is completely removed from the valley 350. The transparent conductive film 2152 may be continuous or broken into several sections lining between the bumps 210 and the substrate 100. FIG. 7B illustrates that in some embodiments, the transparent conductive film 2152 is broken into several sections randomly distributed over the substrate. In some embodiments, the average thickness of the transparent conductive film 2152 in the valley 350 is about 1/4 to about 1/2 of the thickness of the transparent conductive film layer 2152 on the conductive layer 2151.

In some embodiments, first electrode 215 has at least three different films. A conductive film (such as Al, Cu, Ag, Au, etc.) is sandwiched between two transparent conductive films. In some cases, one of the two transparent conductive films is ITO, one side of which is in contact with the substrate 100 and the other side of which is in contact with the conductive film. In some cases, one of the two transparent conductive films is ITO, one side of which is in contact with the conductive film and the other side of which is in contact with the bump 210 or the light-emitting material 205.

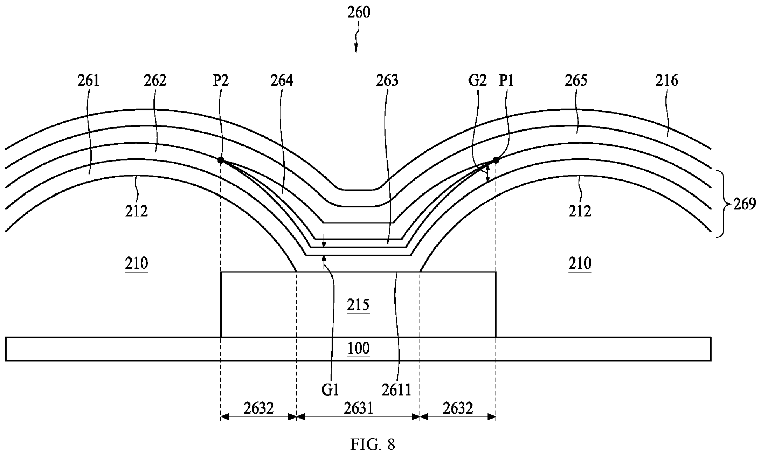

FIG. 8 illustrates an embodiment of a light-emitting device. FIG. 8 is a cross-sectional view of the light-emitting element according to aspects of the disclosure in some embodiments. The light-emitting device includes a substrate 100, bumps 210 above the substrate 100, and a light-emitting unit 260 between the bumps 210 and above the substrate 100.

The light-emitting unit 260 includes a first electrode 215 on the substrate 100, an organic layer 269 on the first electrode 215, and a second electrode 216 on the organic layer 269. The organic layer 269 may be formed by various processes such as vapor deposition, liquid jetting, or inkjet printing. In some embodiments, the absorption rate of the organic layer 269 for a specific wavelength is greater than or equal to 50%. In some embodiments, the absorption rate of the organic layer 269 for a specific wavelength is greater than or equal to 60%. In some embodiments, the absorption rate of the organic layer 269 for a specific wavelength is greater than or equal to 70%. In some embodiments, the absorption rate of the organic layer 269 for a specific wavelength is greater than or equal to 80%. In some embodiments, the absorption rate of the organic layer 269 for a specific wavelength is greater than or equal to 90%. In some embodiments, the absorption rate of the organic layer 269 for a specific wavelength is greater than or equal to 95%. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm. In an embodiment, the light-emitting unit 260 includes a first electrode 215, a first carrier transport layer 262 above the bump 210 and the first electrode 215, a second carrier transport layer 263 above a portion of the first carrier transport layer 262, and an organic emissive layer 264 above the second carrier transport layer 263. In some embodiments, a carrier injection layer 261 is disposed between the first electrode 215 and the first carrier transport layer 262.

In some embodiments, the absorption rate of the organic emissive layer 264 for a specific wavelength is greater than or equal to 50%. In some embodiments, the absorption rate of the organic emissive layer 264 for a specific wavelength is greater than or equal to 60%. In some embodiments, the absorption rate of the organic emissive layer 264 for a specific wavelength is greater than or equal to 70%. In some embodiments, the absorption rate of the organic emissive layer 264 for a specific wavelength is greater than or equal to 80%. In some embodiments, the absorption rate of the organic emissive layer 264 for a specific wavelength is greater than or equal to 90%. In some embodiments, the absorption rate of the organic emissive layer 264 for a specific wavelength is greater than or equal to 95%. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm.

The pattern of the first electrode array is designed according to the pixel arrangement. The pattern of the bumps 210 is designed according to the pixel arrangement, and the patterned bumps 210 may be called a pixel defining layer (PDL). Each bump 210 fills the gap between two adjacent first electrodes 215. Each first electrode 215 is partially covered by the bump 210.

In some embodiments, the carrier injection layer 261 is disposed on the bump 210 and the exposed surface of the first electrode 215. The carrier injection layer 261 continuously covers the bumps 210 and the exposed surfaces of the first electrode 215. In some embodiments, the exposed surface of each first electrode 215 is configured as an effective light-emitting region for one light-emitting unit 260. Optionally, the carrier injection layer 261 is in contact with the PDL bump 210. In some embodiments, the carrier injection layer 261 is in contact with the first electrode 215. In some embodiments, the carrier injection layer 261 is an organism. In some embodiments, the carrier injection layer 261 is configured to perform hole injection. In some embodiments, the carrier injection layer 261 is a hole injection layer.

The first carrier transport layer 262 is disposed on the bump 210 and the exposed surface of the first electrode 215. The carrier injection layer 261 is disposed under the first carrier transport layer 262. The first carrier transport layer 262 continuously covers the carrier injection layer 261. The first carrier transport layer 262 covers a plurality of PDL bumps 210 and a plurality of first electrodes 215. Optionally, the first carrier transport layer 262 is in contact with the carrier injection layer 261. In some embodiments, the first carrier transport layer 262 is an organism. In some embodiments, the first carrier transport layer 262 is configured to perform hole transport. In some embodiments, the first carrier transport layer 262 is a first hole transport layer.

In some embodiments, the carrier injection layer 261 is configured into a plurality of segments, and the first carrier transport layer 262 continuously covers the bumps 210 and exposed portions of segmented carrier injection layer 261. Each section of the carrier injection layer 261 may be vertically aligned with the first electrode 215. In other words, the carrier injection layer 261 does not continuously cover the bump 210 and the exposed portions of the first electrode 215. Each light-emitting unit 260 has a separate carrier injection layer 261 disposed thereon.

The second carrier transport layer 263 is disposed over a portion of the first carrier transport layer 262. The second carrier transport layer 263 may be vertically aligned with the first electrode 215. The second carrier transport layer 263 includes a central region 2631 and a peripheral region 2632 surrounding the central region 2631. In some embodiments, the central region 2631 and the interface 2611 between the carrier injection layer 261 and the first electrode 215 are vertically aligned. In some embodiments, the peripheral region 2632 is vertically aligned with the portion of the light-emitting element between the merging point T1 and the end point E in FIG. 3.

The overlapping portion of the first carrier transport layer 262 and the peripheral region 2632 of the second carrier transport layer 263 has a thickness G2, which is greater than the thickness G1 of the overlapping portion of the first carrier transport layer 262 and the central region 2631 of the second carrier transport layer 263. In some embodiments, the ratio of the thickness of the second carrier transport layer 263 to the thickness of the first carrier transport layer 262 is between 0.1 and 0.7. The second carrier transport layer 263 has a thickness between 1 nm and 100 nm. In some embodiments, the second carrier transport layer 263 has a thickness between 5 nm and 80 nm.

In some embodiments, the thickness of the first carrier transport layer 262 is not uniform, as opposed to the thickness of the second carrier transport layer 263. In contrast to the upper surface of the second carrier transport layer 263, the upper surface of the first carrier transport layer 262 may be rough. In some embodiments, as opposed to the interface between the carrier injection layer 261 and the first carrier transport layer 262, the interface between the first carrier transport layer 262 and the second carrier transport layer 263 between point P1 and point P2 is uneven. The second carrier transport layer 263 may have a better uniformity than the first carrier transport layer 262. In some embodiments, the first carrier transport layer 262 may have better thickness uniformity than the second carrier transport layer 263. In some embodiments, the second carrier transport layer 263 is conformal to the underlying layer, which includes the first carrier transport layer 262 and the carrier injection layer 261 disposed on the bump 210 and the first electrode.

From a cross-sectional perspective, the second carrier transport layer 263 extends from point P1 to point P2 of the first carrier transport layer 262. The first end of the organic emissive layer 264 is at point P1. Similarly, a second end of the organic emissive layer 264 opposite the first end is at point P2. The first carrier transport layer 262 has different thicknesses on both sides of each of point P1 and point P2. For example, the thickness of the first carrier transport layer 262 at one side of point P1 closer to point P2 is greater than that at another side of point P1 away from point P2. Similarly, the thickness of the first carrier transport layer 262 at one side of point P2 closer to point P1 is greater than that at another side of point P2 away from point P1. In some embodiments, the thickness of the first carrier transport layer 262 between points P1 and P2 is less than the thickness of the first carrier transport layer 262 outside of points P1 and P2. The vertical distance between point P1 and the substrate 100 may not be equal to or may be equal to the vertical distance between point P2 and the substrate 100.

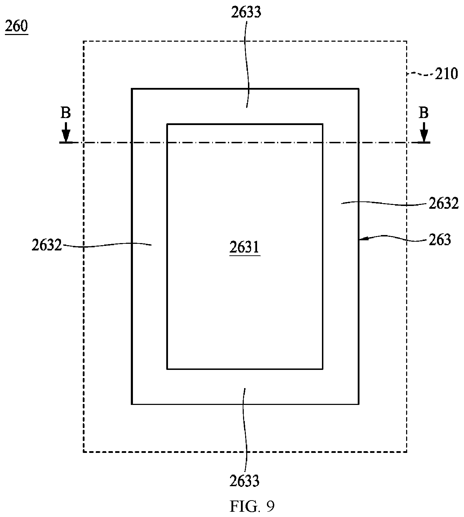

FIG. 9 is a top view of the light-emitting unit 260 shown in FIG. 8 (FIG. 8 is a cross-sectional view taken along line B-B in FIG. 9). The central region 2631 and the peripheral region 2632 are shown as rectangles in FIG. 9, but other shapes may be adopted according to the designer's preference. The surface area of each region depends on the interface 2611 between the carrier injection layer 261 and the first electrode 215. The surface areas of each of the two peripheral regions 2632 disposed on the sides of the central region 2631 may be the same or different.

Another region 2633 of the second carrier transport layer 263 is shown in FIG. 9. The regions 2632 and 2633 may merge into a continuous ring, the ring pattern being the periphery of central region 2631. The width of the ring pattern may not be uniform and may vary from segment to segment. For example, the width of the region 2632 may be different from the width of region 2633 in the same ring. From a top view, the outer boundaries of the regions 2632 and 2633 may be the boundary of the organic emissive layer 264.

Referring back to FIG. 8, in some embodiments, at least one of the first carrier transport layer 262 and the second carrier transport layer 263 includes an organic material. The organic material may include a molecular structure having a resonance structure. The organic material may be selected from a group consisting of spiro-triarylamine, bis-triarylamine and a combination thereof. In some embodiments, at least one of the first carrier transport layer 262 and the second carrier transport layer 263 includes spiro-triarylamine. In some embodiments, at least one of the first carrier transport layer 262 and the second carrier transport layer 263 includes bis-triarylamine. In some embodiments, the first carrier transport layer 262 and the second carrier transport layer 263 include the same material. In some embodiments, the first carrier transport layer 262 includes 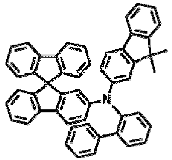 and the second carrier transport layer 263 includes 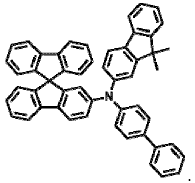 In some embodiments, the first carrier transport layer 262 includes 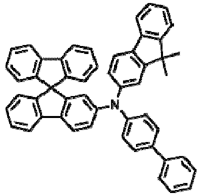 and the second carrier transport layer 263 includes

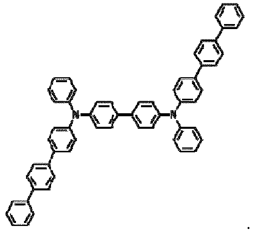

The organic emissive layer 264 is disposed above the second carrier transport layer 263 and completely covers the second carrier transport layer 263. The periphery of the organic emissive layer 264 overlaps with the periphery of the second carrier transport layer 263. The organic emissive layer 264 extends between point P1 and point P2. The organic emissive layer 264 is configured to emit a first color. The organic emissive layer 264 includes an organic light-emitting material.

In some embodiments, the first end of the organic emissive layer 264 intersects the first carrier transport layer 262 and the second carrier transport layer 263 at point P1. The organic emissive layer 264 further has a second end opposite the first end. Similarly, the second end of the organic emissive layer 264 intersects first carrier transport layer 262 and the second carrier transport layer 263 at point P2.

In some embodiments, the organic carrier transport layer 265 is disposed over the organic emissive layer 264. The organic carrier transport layer 265 may be an electron transport layer. In some embodiments, the organic carrier transport layer 265 and the first carrier transport layer 262 are configured for opposite charges respectively.

In some embodiments, the organic carrier transport layer 265 is disposed over the organic emissive layer 264 and completely covers the organic emissive layer 264. The periphery of the organic carrier transport layer 265 may overlap with the periphery of the organic emissive layer 264 and the periphery of the second carrier transport layer 263. The organic carrier transport layer 265 extends between point P1 and point P2. In some embodiments, the organic carrier transport layer 265 is disposed over and continuously covers the organic emissive layer 264 and the portion of the first carrier transport layer 262 exposed through the organic emissive layer 264. In some embodiments, the organic carrier transport layer 265 is in contact with the organic emissive layer 264 and the portion of the first carrier transport layer 262 exposed through the organic emissive layer 264. In some embodiments, the second electrode 216 is disposed over the organic carrier transport layer 265.

In some embodiments, the organic carrier injection layer is disposed between the organic carrier transport layer 265 and the second electrode 216. In some embodiments, the light-emitting unit 260 has a separate organic carrier injection layer. In some embodiments, the organic carrier injection layer is disposed above and continuously covers the organic carrier transport layer 265, and the second electrode 216 is disposed above and continuously covers the organic carrier injection layer. In some embodiments, the organic carrier transport layer 265 is configured to perform electron transport and electron injection. In some embodiments, the organic carrier injection layer is configured to perform electron transport and electron injection. In some embodiments, the organic carrier injection layer is an electron injection layer.

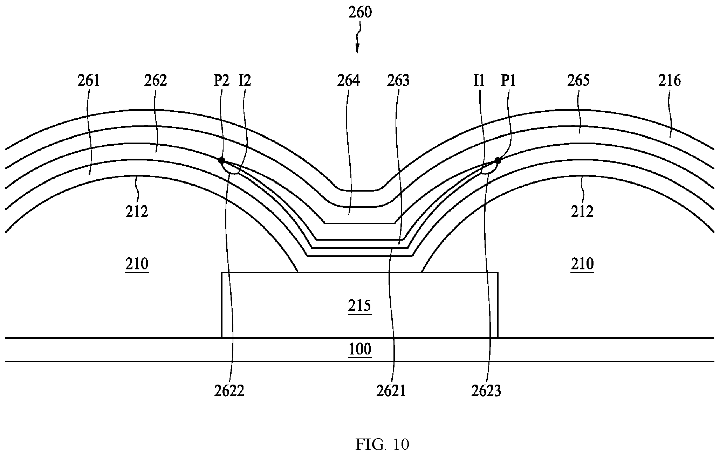

FIG. 10 is a cross-sectional view illustrating another embodiment of a light-emitting device. Referring to FIG. 10, in some embodiments, the interface 2621 between the first carrier transport layer 262 and the second carrier transport layer 263 extends between point P1 and point P2. The interface 2621 can be curved and uneven. In some embodiments, the interface 2621 includes a recess, such as a V-shaped recess. The first carrier transport layer 262 includes a turning point I1 located at the interface 2621 near point P1. The turning point I1 is closer to point P1 than point P2. In some embodiments, point P1 is closer to the apex of the bump 210 than point I1. The interface 2621 is recessed toward the substrate 100 between point P1 and the turning point I1. In other words, the first carrier transport layer 262 includes a recess 2623 between point P1 and the turning point I1. From the turning point I1 to the vicinity of the center of the light-emitting element 260, the interface 2621 forms a convex shape protruding from the substrate 100. In some embodiments, the recess 2623 is a V-shaped recess.

Similarly, another turning point I2 is located at the interface 2621 and close to point P2. The turning point I2 is closer to point P2 than point P1. In some embodiments, point P2 is closer to the apex of the bump 210 than point I2. The interface 2621 is recessed toward the substrate 100 between point P2 and the turning point I2. In other words, the first carrier transport layer 262 includes a recess 2622 between point P2 and the turning point I2. From the turning point I2 to the vicinity of the center of the light-emitting element 260, the interface 2621 forms a convex shape protruding from the substrate 100. In some embodiments, the recess 2622 is a V-shaped recess.

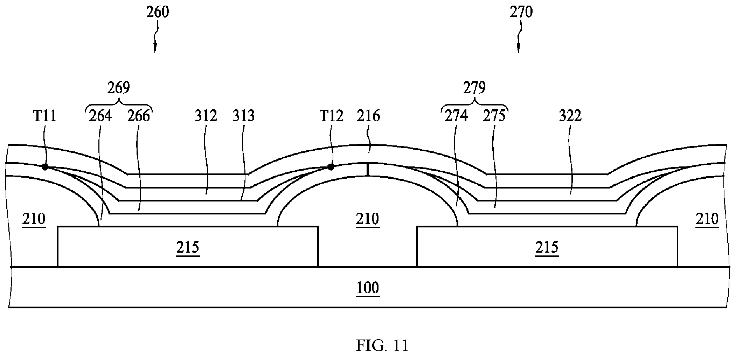

FIG. 11 is a cross-sectional view illustrating a light-emitting element according to another embodiment of the present disclosure. The light-emitting element includes a substrate 100, a plurality of bumps 210 on the substrate 100, and a plurality of light-emitting units separated by the bumps 210.

These light-emitting units include a first light-emitting unit 260 and a second light-emitting unit 270. The light-emitting units 260 and 270 include a first electrode 215 on the substrate 100, organic layers 269 and 279 on the first electrode, and a second electrode 216 on the organic layers 269 and 279. The first light-emitting unit 260 is as described above or as shown in FIGS. 8 to 10, and the second light-emitting unit 270 has a similar structure to the first light-emitting unit 260. Furthermore, although the first and second light-emitting units 260, 270 are illustrated as having similar features, this is only illustrative and is not intended to limit these embodiments. The first light-emitting unit 260 and the second light-emitting unit 270 may have similar structures or different structures to meet desired functional requirements.

In some embodiments, the first light-emitting unit 260 and the second light-emitting unit 270 are adjacent to each other. In some embodiments, the light-emitting device includes a plurality of light-emitting units, and the first and second light-emitting units 260, 270 may be any two of the plurality of light-emitting units. Those skilled in the art will readily appreciate that any suitable number of light-emitting units may be employed, and all such combinations are fully intended to be included within the scope of these embodiments.

In some embodiments, the first light-emitting unit 260 is configured to display a first color, and the second light-emitting unit 270 is configured to display a second color different from the first color. The thickness of the organic layers 269, 279 may be related to the color displayed by the corresponding light-emitting unit 260, 270. The organic layers 269, 279 may have different thicknesses. In some embodiments, the thickness of the previously formed organic layer 269 of the first light-emitting unit 260 is less than the thickness of the later formed organic layer 279 of the second light-emitting unit 270, and the wavelength of the light emitted by the first light-emitting unit 260 is greater than the wavelength of the light emitted by the second light-emitting unit 270. In some embodiments, the first light-emitting unit 260 emits green light or red light. In some embodiments, the first light-emitting unit 260 emits green light, and the second light-emitting unit 270 emits red light or blue light. The organic layers 269, 279 may be formed by various processes such as vapor deposition, liquid jetting, or inkjet printing.

In some embodiments, the thickness of the organic layer 269 of the first light-emitting unit 260 is about 20% to about 80% of the thickness of the organic layer 279 of the second light-emitting unit 270. In some embodiments, the thickness of the organic layer 269 of the first light-emitting unit 260 is about 30% to about 50% of the thickness of the organic layer 279 of the second light-emitting unit 270.

In some embodiments, the thickness uniformity of the organic layer 269 of the first light-emitting unit 260 is greater than the thickness uniformity of the organic layer 279 of the second light-emitting unit 270. In some embodiments, the brightness of the first light-emitting unit 260 is less than the brightness of the second light-emitting unit 270.

In some embodiments, each of the organic layers 269, 279 includes an organic emissive layer 264, 274 on the first electrode 215, and an electrode transport layer 266, 275 disposed over the organic emissive layer 264, 274. In some embodiments, the thickness of the electrode transport layer 266 of the first light-emitting unit 260 is less than the thickness of the electrode transport layer 275 of the second light-emitting unit 270. The thickness of the electrode transport layer 266 of the first light-emitting unit 260 is about 20% to about 80% of the thickness of the electrode transport layer 275 of the second light-emitting unit 270. In some embodiments, the thickness uniformity of the electrode transport layer 266 of the first light-emitting unit 260 is greater than the thickness uniformity of the electrode transport layer 275 of the second light-emitting unit 270. In some embodiments, each electrode transport layer 266, 275 includes a sub-layer.

The thickness of the organic emissive layer 264 of the first light-emitting unit 260 may be substantially equal to the thickness of the organic emissive layer 274 of the second light-emitting unit 270.

From a cross-sectional perspective, the first light-emitting unit 260 further includes an intermediate layer 312 between the organic layer 269 and the second electrode 216. In some embodiments, the thickness of the intermediate layer 312 is not uniform, and the second electrode 216 is conformal to the intermediate layer 312.

In some embodiments, the thickness of the organic layer 269 is not uniform. The uneven thickness of the organic layer 269 may be caused by the manufacturing process of the light-emitting element. In some embodiments, the thickness of the organic layer 269 is related to the thickness of the intermediate layer 312. In some embodiments, the less the thickness of the organic layer 269 is, the greater the thickness of the intermediate layer 312 will be.

In some embodiments, the upper surface 313 of the organic layer 269 is the interface between the organic layer 269 and the intermediate layer 312. Due to the manufacturing process of the light-emitting element, the upper surface 313 may be rough and uneven. In some embodiments, the roughness of the upper surface 313 is not uniform, the upper surface 313 includes many areas with varying roughness, and the roughness of an area is related to the thickness of the intermediate layer 312 where the area contacts. In some embodiments, the rougher the upper surface 313 of the organic layer 269, the thicker the thickness of the intermediate layer 312.

The organic layer 269 of the first light-emitting unit 260 includes a first material, the second electrodes 216 of the first light-emitting unit 260 and the second light-emitting unit 270 include an electrode material, and the intermediate layer 312 of the first light-emitting unit 260 includes the first material and the electrode material. In some embodiments, the concentration of the electrode material in the intermediate layer 312 decreases from the second electrode 216 toward the organic layer 269 of the first light-emitting unit 260. In some embodiments, the formation of the intermediate layer 312 includes diffusing the electrode material of the second electrode 216 into the organic layer 269 of the first light-emitting unit 260.

In some embodiments, the intermediate layer 312 of the first light-emitting unit 260 further includes a third material. The third material is a reactant from the first material and the electrode material, or is formed by chelation of the first material and the electrode material. In some embodiments, the intermediate layer 312 of the first light-emitting unit 260 includes a central region and a peripheral region surrounding the central region. The amount of the third material in the central region of the intermediate layer 312 is greater than the amount of the third material in the peripheral region of the intermediate layer 312 in the first light-emitting unit 260.

From a cross-sectional view, the two opposite ends of the intermediate layer 312 in the first light-emitting unit 260 merge with the organic layer 269 and the second electrode 216 at the first merging point T11 and the second merging point T12 respectively. In some embodiments, the distance between the first meeting point T11 and the substrate 100 is different from the distance between the second meeting point T12 and the substrate 100.

In some embodiments, each bump 210 has a curved surface that protrudes away from the substrate 100 and covers the peripheral region of the first electrode 215. The first light-emitting unit 260 overlaps the bump 210 at two opposite sides of the first light-emitting unit 260, wherein a first overlap width and a second overlap width of the two opposite sides of the first light-emitting unit 260, which are measured along the axis on the bump 210, are substantially the same, and the distance between the first merging point T11 and the substrate 100 may be similar to the distance between the second merging point T12 and the substrate 100. The second light-emitting unit 270 overlaps the bump 210 at the side of the second light-emitting unit 270, and a third overlap width of the second light-emitting unit 270, which is measured along the X-axis on the bump 210, is different from the first overlap width and the second overlap width of the first light-emitting unit 260. In some embodiments, the first light-emitting unit 260 and the second light-emitting unit 270 are arranged as described above or as shown in FIG. 4A. In some embodiments, the difference between the first overlap width and the third overlap width is about 0.1% to about 60% of the width of the first light-emitting unit 260.

In some embodiments, the second light-emitting unit 270 further includes an intermediate layer 322 between the organic layer 279 and the second electrode 216. The organic layer 279 of the second light-emitting unit 270 includes a second material, and the intermediate layer 322 of the second light-emitting unit 270 includes the second material and the electrode material. In some embodiments, the amount of the electrode material in the intermediate layer 322 of the second light-emitting unit 270 is less than the amount of the electrode material in the intermediate layer 312 of the first light-emitting unit 260.

In some embodiments, the intermediate layer 322 of the second light-emitting unit 270 further includes a fourth material. The fourth material is a reactant from the second material and the electrode material, or is formed by chelation of the second material and the electrode material. The intermediate layer 322 of the second light-emitting unit 270 may include a central region and a peripheral region surrounding the central region. The amount of the fourth material in the central region of the intermediate layer 322 is greater than the amount of the fourth material in the peripheral region of the intermediate layer 312.

In some embodiments, the ratio of the thickness of the intermediate layer 322 in the second light-emitting unit 270 to the thickness of the intermediate layer 312 in the first light-emitting unit 260 is between 0.001 and 0.2. The thickness of the organic layers 269, 279 may be related to the thickness of the intermediate layers 312, 322. In some embodiments, the thickness of the organic layer 269 in the first light-emitting unit 260 is less than the thickness of the organic layer 279 in the second light-emitting unit 270, and the thickness of the intermediate layer 312 in the first light-emitting unit 260 is larger than the thickness of the intermediate layer 322 in the second light-emitting unit 270.

In some embodiments, the thickness uniformity of the intermediate layer 312 of the first light-emitting unit 260 is greater than the thickness uniformity of the intermediate layer 322 of the second light-emitting unit 270. The thickness uniformity of the intermediate layers 312, 322 may be related to the diffusion of the electrode material of the second electrode 216. In some embodiments, the greater the thickness uniformity of the organic layers 269, 279 is, the greater the degree of diffusion of the electrode material will be, which means the greater the thickness of the intermediate layers 312, 322 will be. In some embodiments, the thickness uniformity of the intermediate layer 312 in the first light-emitting unit 260 is greater than the thickness uniformity of the intermediate layer 322 in the second light-emitting unit 270, and the thickness of the intermediate layer 312 in the first light-emitting unit 260 is greater than the thickness of the intermediate layer 322 in the second light-emitting unit 270.

In some embodiments, the second electrode 216 is divided into several blocks, and each block is arranged in a light-emitting unit. In some embodiments, the first and second light-emitting units 260, 270 share a common second electrode 216.

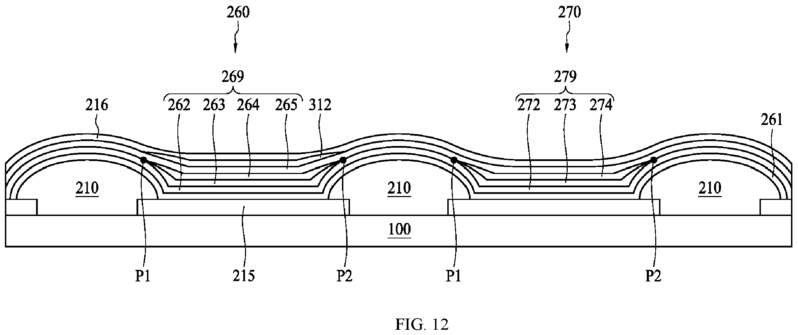

FIG. 12 is a cross-sectional view illustrating a light-emitting device according to another embodiment of the present disclosure. In some embodiments, each of the organic layers 269, 279 further includes the first carrier transport layer 262, 272 between the organic emissive layer 264, 274 and the first electrode 215. In some embodiments, the thickness of the first carrier transport layer 262 of the first light-emitting unit 260 is greater than the thickness of the first carrier transport layer 272 of the second light-emitting unit 270. In some embodiments, the thickness uniformity of the first carrier transport layer 262 of the first light-emitting unit 260 is less than the thickness uniformity of the first carrier transport layer 272 of the second light-emitting unit 270. In some embodiments, the first carrier transport layer 272 is a second hole transport layer.

In some embodiments, the thickness of the second carrier transport layer 263 of the first light-emitting unit 260 is different from the thickness of the second carrier transport layer 273 of the second light-emitting unit 270. In some embodiments, the total thickness of the first carrier transport layer 262 and the second carrier transport layer 263 of the first light-emitting unit 260 is substantially equal to the total thickness of the first carrier transport layer 272 and the second carrier transport layer 273 of the second light-emitting unit 270. In some embodiments, the thickness of the first carrier transport layer 262 of the first light-emitting unit 260 is greater than the thickness of the first carrier transport layer 272 of the second light-emitting unit 270, and the thickness of the second carrier transport layer 263 of the first light-emitting unit 260 is less than the thickness of the second carrier transport layer 273 of the second light-emitting unit 270.

The first light-emitting unit 260 and the second light-emitting unit 270 may have an organic carrier transport layer 265 above the organic emissive layer 264 of the first light-emitting unit 260 and the second light-emitting unit 270 and above the intermediate layer 312 of the first light-emitting unit 260. In some embodiments, the first and second light-emitting units 260, 270 share a common organic carrier transport layer 265. The organic carrier transport layer 265 is located over the bumps 210 and the organic emissive layer 264 of the first and second light-emitting units 260, 270. In some embodiments, the second electrode 216 is disposed over the intermediate layer 312 and the exposed portions of the organic carrier transport layer 265.

In some embodiments, the light-emitting device further includes the carrier injection layer 261 (that is of the same type as the first carrier transport layer 262), which is disposed over and continuously covers the bump 210 and the first electrode 215. The organic emissive layer 264 of the first light-emitting unit 260 may be disposed between the second carrier transport layer 263 and the corresponding organic carrier transport layer 265. The organic carrier transport layer 265 of the first light-emitting unit 260 and the second light-emitting unit 270 may be an electron transport layer. Similarly, the organic emissive layer 274 of the second light-emitting unit 270 may be disposed between the second carrier transport layer 273 and the corresponding organic carrier transport layer 265.

Each of the first light-emitting unit 260 and the second light-emitting unit 270 includes a point P1 and a point P2. Each of points P1 and P2 represents a position where one end of the second carrier transport layer 263, 273 meets the corresponding organic emissive layer 264, 274 and the first carrier transport layer 262, 272. In some embodiments, from a cross-sectional view, each of the first light-emitting unit 260 and the second light-emitting unit 270 includes points P1 and P2 located at two opposite ends of the second carrier transport layer 263, 273 respectively. Point P1 and point P2 are located at two opposite ends of the organic emissive layers 264 and 274 respectively.

The vertical distance between point P1 and the substrate 100 of the first light-emitting unit 260 may be similar to or different from the vertical distance between point P1 and the substrate 100 of the second light-emitting unit 270. Similarly, the vertical distance between point P2 and the substrate 100 of the first light-emitting unit 260 may be similar to or different from the vertical distance between point P2 and the substrate 100 of the second light-emitting unit 270. The distance between point P1 and point P2 of the first light-emitting unit 260 may be similar to or different from the distance between point P1 and point P2 of the second light-emitting unit 270.

In some embodiments, when the first color is green and the second color is red or blue, or when the first color is red and the second color is blue, the first carrier transport layer 262 of the first light-emitting unit 260 is thinner than the first carrier transport layer 272 of the second light-emitting unit 270.

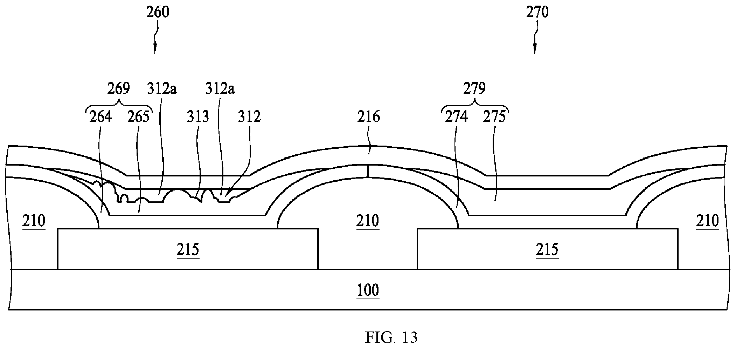

FIG. 13 is a cross-sectional view illustrating a light-emitting device according to another embodiment of the present disclosure. In some embodiments, the intermediate layer 312 of the first light-emitting unit 260 includes a plurality of discontinuous sections 312a, wherein each section 312a is disposed in the first light-emitting unit 260. The shape and size of the section 312a may be the same or different depending on actual needs.

The section 312a is provided on the upper surface 313. In some embodiments, the upper surface 313 includes numerous areas of varying roughness, and the sections 312a are formed on relatively rough areas of the upper surface 313. In some embodiments, the upper surface 313 of the previously formed organic layer 269 of the first light-emitting unit 260 may include a recess, such as a V-shaped recess, and the section 312a is disposed in the recess.

In some embodiments, the intermediate layer 322 of the second light-emitting unit 270 includes a plurality of discontinuous sections (not shown). The shapes and sizes of the sections of the intermediate layer 322 may be the same or different according to actual needs. In some embodiments, the number of sections of the intermediate layer 322 in the second light-emitting unit 270 is less than the number of sections 312a of the intermediate layer 312 in the first light-emitting unit 260. In some embodiments, the size of the section of the intermediate layer 322 in the second light-emitting unit 270 is smaller than the size of the section 312a of the intermediate layer 312 in the first light-emitting unit 260.

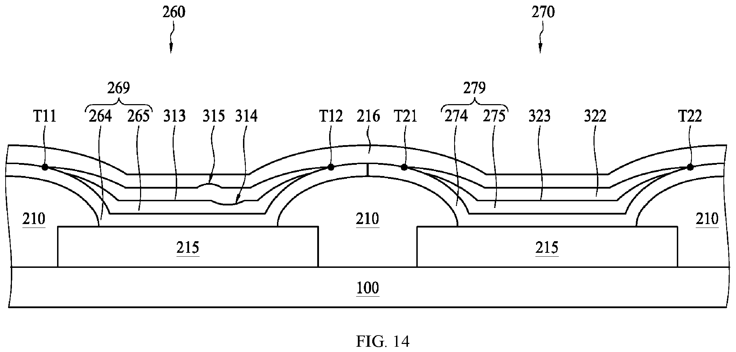

FIG. 14 is a cross-sectional view illustrating a light-emitting device according to another embodiment of the present disclosure. In some embodiments, the organic layer 269 of the first light-emitting unit 260 includes an upper surface 313 of the organic layer 269 and a recess 314 formed in the upper surface 313. The intermediate layer 312 of the first light-emitting unit 260 is disposed in the recess 314. In some embodiments, the intermediate layer 312 of the first light-emitting unit 260 further covers a portion of the upper surface 313 of the organic layer 269 of the first light-emitting unit 260. In some embodiments, a plurality of recesses 314 is formed in the upper surface 313. The shape and size of each recess 314 may be the same or different according to actual needs.

In some embodiments, the upper surface of the intermediate layer 312 in the first light-emitting unit 260 includes a protrusion 315. The protrusion 315 may penetrate into the second electrode 216. In some embodiments, the upper surface of the intermediate layer 312 in the first light-emitting unit 260 includes a plurality of protrusions 315.

In some embodiments, the intermediate layer 322 of the second light-emitting unit 270 includes an upper surface 323. Contrary to the upper surface 323 of the intermediate layer 322 in the second light-emitting unit 270, the upper surface 313 of the intermediate layer 312 in the first light-emitting unit 260 may be rough. In some embodiments, contrary to the upper surface 323 of the intermediate layer 322 in the second light-emitting unit 270, the upper surface 313 of the intermediate layer 312 in the first light-emitting unit 260 is uneven.

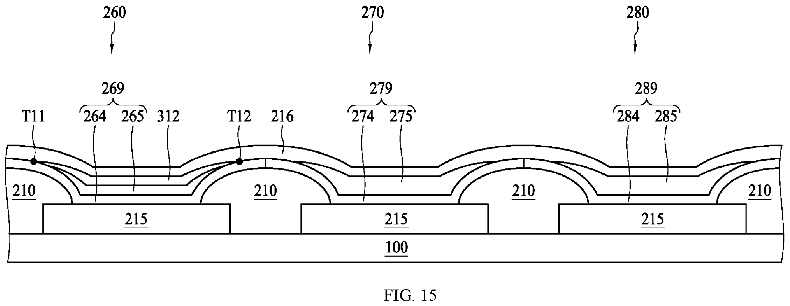

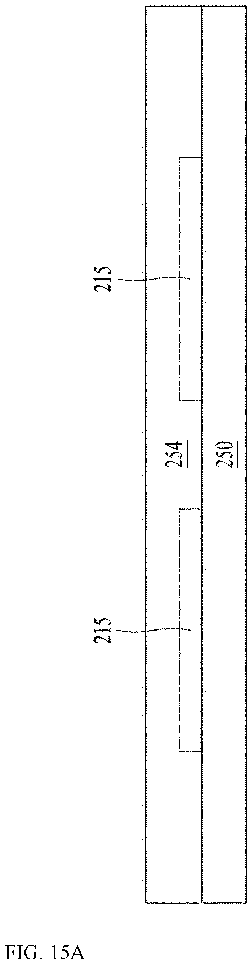

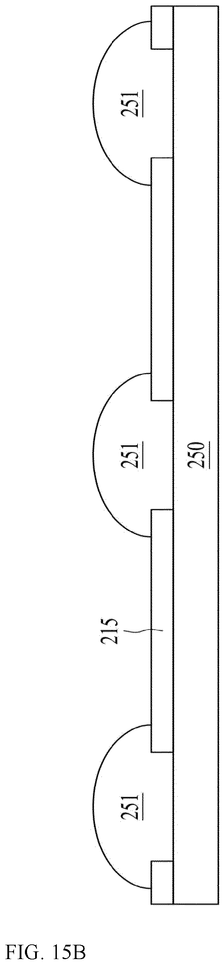

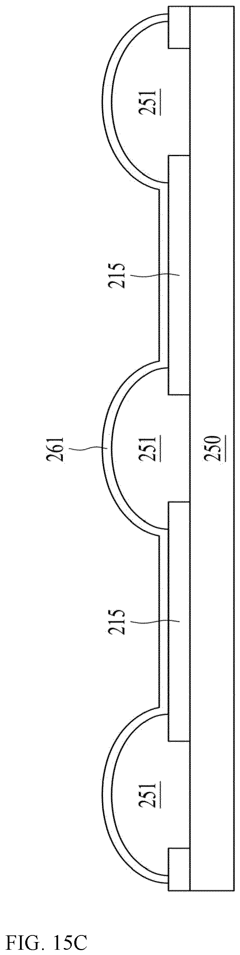

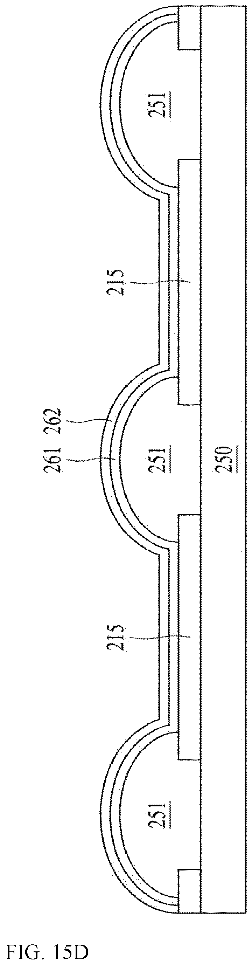

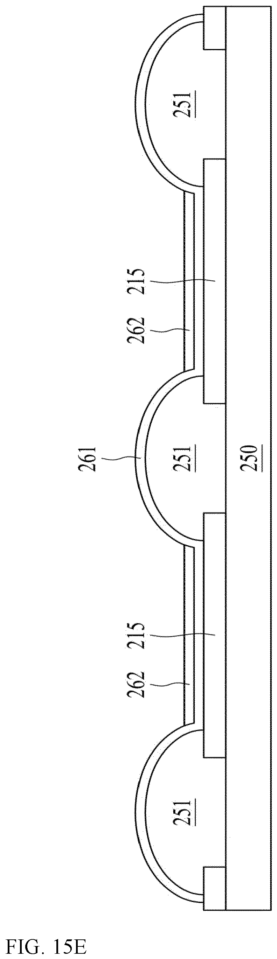

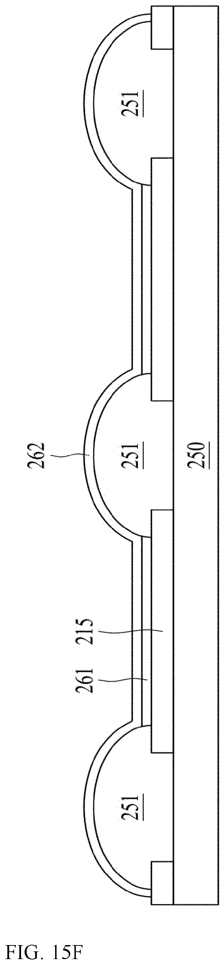

FIG. 15 is a cross-sectional view illustrating a light-emitting device according to another embodiment of the present disclosure. In some embodiments, the light-emitting device further includes a third light-emitting unit 280. Although the second and third light-emitting units 270, 280 are illustrated in FIG. 15 as having similar features, this is for illustration only and is not intended to limit these embodiments. The second light-emitting unit 270 and the third light-emitting unit 280 may have similar structures or different structures to meet desired functional requirements. The first, second and third light-emitting units 260, 270, 280 may differ from each other in at least the thickness of the organic layer 269, 279, 289. In some embodiments, the first light-emitting unit 260 emits green light, the second light-emitting unit 270 emits red light, and the third light-emitting unit 280 emits blue light.

In some embodiments, the light-emitting units 260, 270, 280 are configured to be divided into at least three different groups, among which each group emits a different color than the other groups. The thickness of each organic layer 269, 279, 289 may be related to the color displayed by the corresponding light-emitting unit 260, 270, 280. In some embodiments, the first light-emitting unit 260 emits green light and the organic layer 269 of the first light-emitting unit 260 may have a minimum thickness, compared to other light-emitting units configured to emit different colors. In some embodiments, the second light-emitting unit 270 emits red light and the thickness of the organic layer 279 in the second light-emitting unit 270 may be between the thickness of the organic layer 269 in the first light-emitting unit 260 and the thickness of the organic layer 289 in the third light-emitting unit 280, compared to other light-emitting units configured to emit different colors. In some embodiments, the third light-emitting unit 280 emits blue light and the organic layer 289 of the third light-emitting unit 280 may have a maximum thickness, compared to other light-emitting units configured to emit different colors.

In some embodiments, the third light-emitting unit 280 further includes an intermediate layer (not shown) between the organic layer 289 and the second electrode 216. The thickness of the organic layer 289 in the third light-emitting unit 280 is less than the thickness of the intermediate layer 312 in the first light-emitting unit 260. In some embodiments, the thickness of the organic layer 289 in the third light-emitting unit 280 is less than the thickness of the intermediate layer 322 in the second light-emitting unit 270.

In some embodiments, the first, second and third light-emitting units 260, 270, 280 may differ from each other at least in the thickness of the first carrier transport layer 262 of the first, second and third light-emitting units 260, 270, 280.

In some embodiments, the light-emitting units 260, 270, 280 are configured to be divided into at least three different groups, among which each group emits a different color than the other groups. The thickness of the first carrier transport layer 262 may be related to the color displayed by the corresponding light-emitting unit 260. In some embodiments, the first light-emitting unit 260 emits green light and the first carrier transport layer 262 of the first light-emitting unit 260 may have a minimum thickness, compared to other light-emitting units configured to emit different colors. In some embodiments, the second light-emitting unit 270 emits red light and the thickness of the first carrier transport layer 272 in the second light-emitting unit 270 may be between the thickness of the first carrier transport layer 262 in the first light-emitting unit 260 and the thickness of the first carrier transport layer 282 in the third light-emitting unit 280, compared to other light-emitting units configured to emit different colors. In some embodiments, the third light-emitting unit 280 emits blue light and the first carrier transport layer of the third light-emitting unit 280 may have a maximum thickness, compared to other light-emitting units configured to emit different colors.

As mentioned above, each light-emitting unit has a plurality of organic light-emitting layers stacked on its first electrode 215 in a direction perpendicular to the first electrode 215 to form an organic light-emitting stack layer. It is worth noting that each organic light-emitting layer of the organic light-emitting stack layer may not be clearly identifiable under a microscope. The organic light-emitting stack layer has a total thickness, which is defined as the distance from the interface between the organic light-emitting stack layer and the first electrode 215 to the interface between the organic light-emitting stack layer and the second electrode 216 along the direction perpendicular to the first electrode 215.

In one embodiment, there is a first light-emitting unit and a second light-emitting unit, wherein the first light-emitting unit and the second light-emitting unit each have an organic light-emitting stack layer including an organic material and emit light with different colors, wherein the total thickness of the organic light-emitting stack layer of the first light-emitting unit is greater than the total thickness of the organic light-emitting stack layer of the second light-emitting unit. In one embodiment, the first light-emitting unit and the second light-emitting unit mentioned above are adjacent to each other.

In one embodiment, there is a first light-emitting unit having a total thickness of 1.5-2 times the total thickness of the second light-emitting unit. In one embodiment, there is a first light-emitting unit having a total thickness of 1.3-1.5 times the total thickness of the second light-emitting unit. In one embodiment, there is a first light-emitting unit having a total thickness of 1.2-1.3 times the total thickness of the second light-emitting unit.

In one embodiment, there are a first light-emitting unit, a second light-emitting unit and a third light-emitting unit, wherein the first, second and third light-emitting units each have an organic light-emitting stack layer including an organic material and emit light with different colors, wherein the total thickness of the organic light-emitting stack layer of the first light-emitting unit is greater than the total thickness of the organic light-emitting stack layer of the second light-emitting unit, and the total thickness of the organic light-emitting stack layer of the second light-emitting unit is greater than the total thickness of the organic light-emitting stack layer of the third light-emitting unit. In one embodiment, the light-emitting units described above may be adjacent to each other.

In FIG. 15A, a substrate 250 is provided. The substrate 250 may include a thin film transistor (TFT) array. A plurality of first electrodes 215 are provided on the substrate 250. Each first electrode 215 is configured to be connected to the circuit embedded in the substrate 250 on one side and to contact the light-emitting material on the other side. The array pattern of the first electrode is designed considering the arrangement of pixels. A photosensitive layer 254 is provided on the first electrode 215 and the substrate 250. In some embodiments, the photosensitive layer 254 is coated on the first electrode 215 and the substrate 250.

The photosensitive layer 254 fills the gaps between adjacent first electrodes 215. The photosensitive layer 254 is heated to a predetermined temperature and then exposed to a specified wavelength. The photosensitive layer 254 can absorb more than 90% of visible light, and is also referred to as a black body material in this disclosure. After exposure, the photosensitive layer 254 is wetted in a solution for development. As shown in FIG. 15B, a portion of the photosensitive layer 254 is removed, and the remaining portion substantially covers the gap between adjacent first electrodes 215. In this cross-sectional view, the remaining photosensitive layer 254 forms a plurality of bumps 251, and each bump 251 fills the gap between adjacent first electrodes 215. The bumps 251 partially cover each first electrode 215. The patterned bumps 251 are also called the pixel defined layer (PDL).

The bumps 251 may be formed into different shapes. In FIG. 15B, the bump 251 has a curved surface. In some embodiments, the bump 251 is trapezoidal in shape. After the bumps 251 are formed, a cleaning operation is performed to clean the exposed surfaces of the bumps 251 and the first electrode 215. In one embodiment, during the cleaning operation, the deionized water is heated to a temperature between 30°C and 80°C. After the temperature of the deionized water rises to a predetermined temperature, the deionized water is introduced to the exposed surfaces of the bump 251 and the first electrode 215.

In some embodiments, ultrasonic waves are used during the cleaning operation. Ultrasonic waves are introduced into the cleaning agent (such as water or isopropyl alcohol (IPA), etc.). In some embodiments, carbon dioxide is introduced into the cleaning agent. After the cleaning operation, the cleaning agent is removed from the exposed surface through a heating operation. During the heating operation, the substrate 250 and the bumps 251 may be heated to a temperature between 80°C and 110°C. In some instances, compressed air is introduced to the exposed surfaces to help remove residue of the cleaning agent while applying heat.

After the heating operation, O₂, N₂, or Ar plasma may be used to treat the exposed surface. Plasma is used to roughen the exposed surfaces. In some embodiments, ozone is used to condition the surface of the exposed surfaces.

As shown in FIG. 15C, a carrier injection layer 261 is provided on the exposed surfaces of the bump 251 and the first electrode 215. The carrier injection layer 261 is continuously lining along the exposed surfaces. More specifically, the exposed surface of each first electrode 215 is configured as an effective light-emitting region of a light-emitting unit. In this embodiment, all light-emitting units use a common carrier injection layer 261. In some embodiments, the carrier injection layer 261 is used for hole injection. In some embodiments, the carrier injection layer 261 is used for electron injection. The carrier injection layer 261 continuously covers the plurality of PDL bumps 251 and the first electrodes 215. Optionally, the carrier injection layer 261 is in contact with the PDL bumps 251. In one embodiment, the carrier injection layer 261 is in contact with the first electrodes 215. In some embodiments, the carrier injection layer 261 is organic.

As shown in FIG. 15D, a carrier transport layer 262 (or referred to as a first type carrier transport layer) is provided on the exposed surfaces of the bumps 251 and the first electrodes 215. The carrier injection layer 261 is provided below the carrier transport layer 262. The carrier transport layer 262 continuously lines along the carrier injection layer 261. In this embodiment, all light-emitting units use a common carrier transport layer 262. In some embodiments, the carrier transport layer 262 is used for hole injection. In some embodiments, the carrier transport layer 262 is used for electron injection. The carrier transport layer 262 continuously covers the plurality of PDL bumps 251 and the first electrodes 215. Optionally, the carrier transport layer 262 is in contact with the carrier injection layer 261. In some embodiments, the carrier transport layer 262 is organic.

In some embodiments, as shown in FIG. 15E, the carrier transport layer 262 is configured into segments, while the exposed PDL bumps 251 and first electrodes 215 are continuously lined with the carrier injection layer 261. Each segment is arranged vertically relative to a first electrode 215. In other words, the carrier transport layer 262 does not continuously line along the carrier injection layer 261. Each light-emitting unit has an individual carrier transport layer 262 disposed thereon.

In some embodiments, as shown in FIG. 15F, the carrier injection layer 261 is configured into segments, while the carrier transport layer 262 continuously lines along the exposed PDL bumps 251 and the first electrodes 215. Each segment is arranged vertically relative to a first electrode 215. In other words, the carrier injection layer 261 does not continuously line along the exposed bumps 251 and the first electrodes 215. Each light-emitting unit has an individual carrier injection layer 261 disposed thereon.

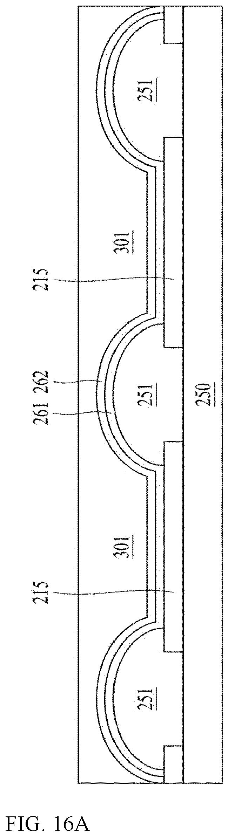

As shown in FIG. 16A, the buffer layer 301 is disposed on the PDL bumps 251 and also covers the carrier injection layer 261 and the carrier transport layer 262. The buffer layer 301 is used to prevent water vapor from penetrating into the PDL bumps 251, the carrier injection layer 261, and the carrier transport layer 262. In one embodiment, the buffer layer 301 is provided by spin coating. The buffer layer 301 may be further heated to a temperature T1. In some embodiments, T1 is about 5°C to 10°C, which is lower than the glass transition temperature of the carrier injection layer 261 and the carrier transport layer 262. This heating operation takes about 1 to 10 minutes. In some embodiments, the buffer layer 301 includes fluorine.

In some embodiments, the absorption rate of the buffer layer 301 for a specific wavelength is greater than or equal to 30%. In some embodiments, the absorption rate of the buffer layer 301 for a specific wavelength is greater than or equal to 40%. In some embodiments, the absorption rate of the buffer layer 301 for a specific wavelength is greater than or equal to 50%. In some embodiments, the absorption rate of the buffer layer 301 for a specific wavelength is greater than or equal to 60%. In some embodiments, the absorption rate of the buffer layer 301 for a specific wavelength is greater than or equal to 70%. In some embodiments, the absorption rate of the buffer layer 301 for a specific wavelength is greater than or equal to 80%. In some embodiments, the absorption rate of the buffer layer 301 for a specific wavelength is greater than or equal to 90%. In some embodiments, the absorption rate of the buffer layer 301 for a specific wavelength is greater than or equal to 95%. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm.

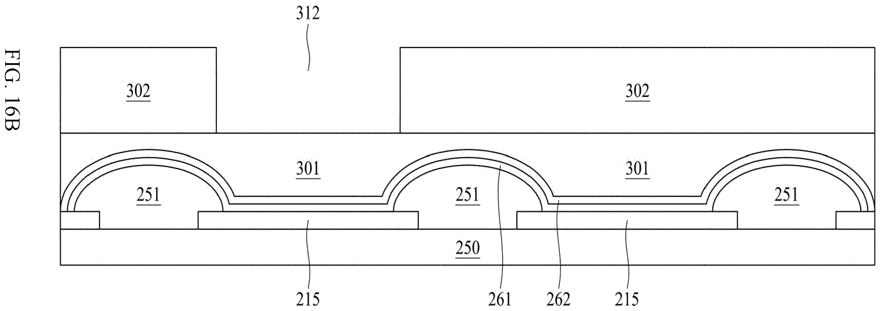

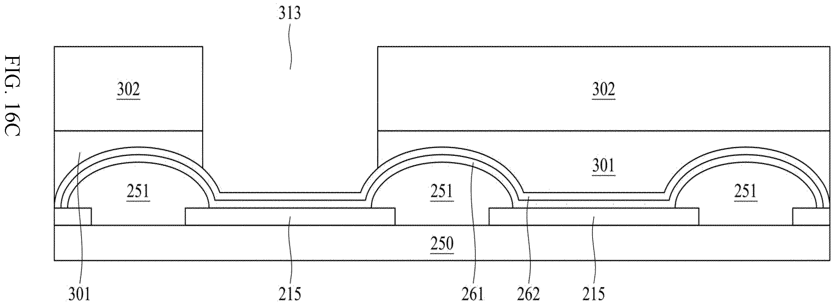

In FIG. 16B, after the heating operation, the photosensitive layer 302 is provided on the buffer layer 301. The photosensitive layer 302 may be further patterned through the lithography process, so that a portion of the buffer layer 301 is exposed through the trench 312. In FIG. 16C, a portion of buffer layer 301 is removed to have the trench 313, thereby exposing the carrier transport layer 262. In some embodiments, the removal operation of FIG. 16C is performed by wet etching.

In some embodiments, the absorption rate of the photosensitive layer 302 for a specific wavelength is greater than or equal to 30%. In some embodiments, the absorption rate of the photosensitive layer 302 for a specific wavelength is greater than or equal to 40%. In some embodiments, the absorption rate of the photosensitive layer 302 for a specific wavelength is greater than or equal to 50%. In some embodiments, the absorption rate of the photosensitive layer 302 for a specific wavelength is greater than or equal to 60%. In some embodiments, the absorption rate of the photosensitive layer 302 for a specific wavelength is greater than or equal to 70%. In some embodiments, the absorption rate of the photosensitive layer 302 for a specific wavelength is greater than or equal to 80%. In some embodiments, the absorption rate of the photosensitive layer 302 for a specific wavelength is greater than or equal to 90%. In some embodiments, the absorption rate of the photosensitive layer 302 for a specific wavelength is greater than or equal to 95%. In some embodiments, the specific wavelength is not greater than 400 nm. In some embodiments, the specific wavelength is not greater than 350 nm. In some embodiments, the specific wavelength is not greater than 300 nm. In some embodiments, the specific wavelength is not greater than 250 nm. In some embodiments, the specific wavelength is not greater than 200 nm. In some embodiments, the specific wavelength is not greater than 150 nm. In some embodiments, the specific wavelength is not greater than 100 nm.

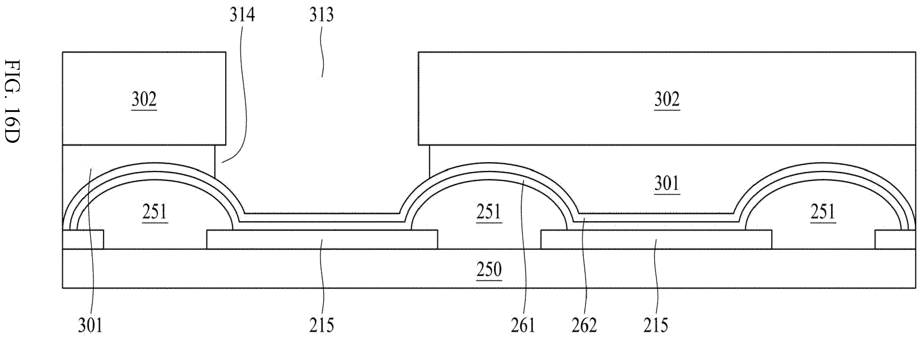

For some embodiments, the removal operation includes at least two steps. The first step is vertical removal, in which the buffer layer 301 is cut out roughly according to the size of the opening width of the trench 312, as shown in FIG. 16C. After the trench 313 is formed, a second step is performed for lateral removal, as shown in FIG. 16D. The lateral recess 314 is formed so that the trench 313 extends further into the buffer layer 301 to expose more surface toward the highest point of the PDL bump 251.

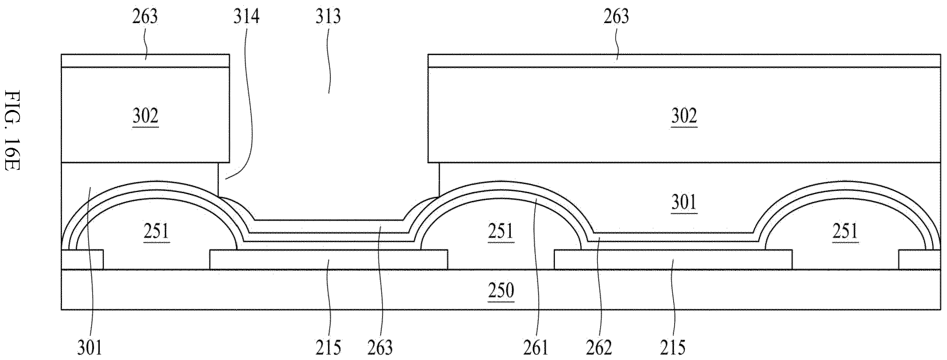

An organic emissive (EM) layer 263 is disposed in the trench 313 and covers the carrier transport layer 262 and the photosensitive layer 302. In FIG. 16E, the EM layer 263 completely covers the exposed carrier transport layer 262. The EM layer 263 is configured to emit the first color.

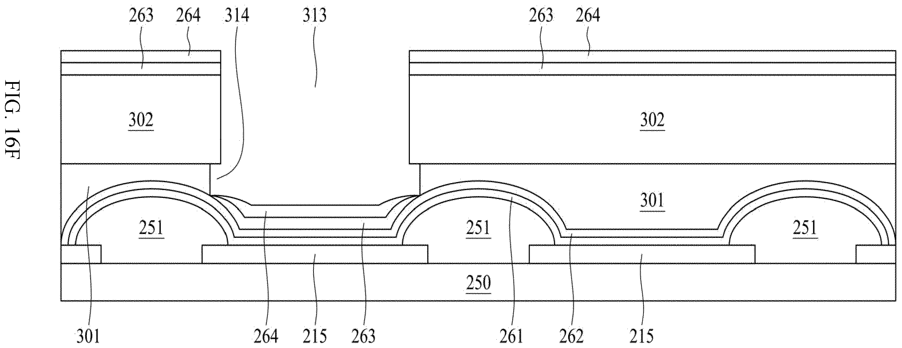

As shown in FIG. 16F, an organic carrier transport layer 264 (or a second-type carrier transport layer) is provided on the EM layer 263. The organic carrier transport layer 264 may be a hole or electron transport layer 264. In some embodiments, the organic carrier transport layer 264 and the carrier transport layer 262 are configured in opposite valence states respectively.

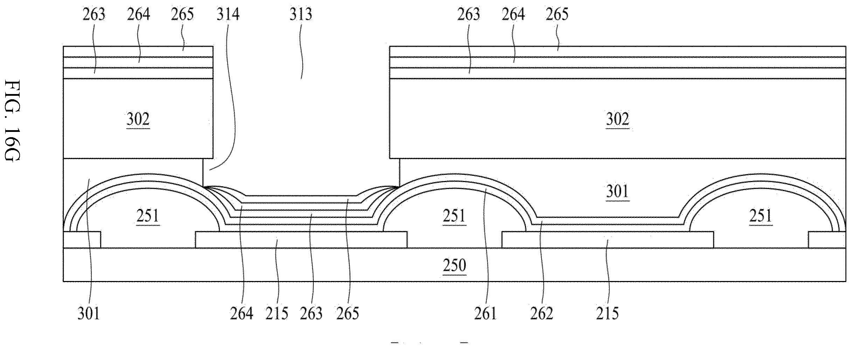

In FIG. 16G, a second electrode 265 is provided on the organic carrier transport layer 264. The top surface of the photosensitive layer 302 is also covered by the second electrode 265. After the second electrode 265 is formed, the photosensitive layer 302 can be removed. The second electrode 265 may be made of a metal material, such as Ag, Mg, etc. In some embodiments, the second electrode 265 includes ITO (indium tin oxide) or IZO (indium zinc oxide). In some embodiments, when viewed from the cross-sectional view, each light-emitting unit has an independent second electrode 265, and a plurality of light-emitting units share a common carrier transport layer 264.

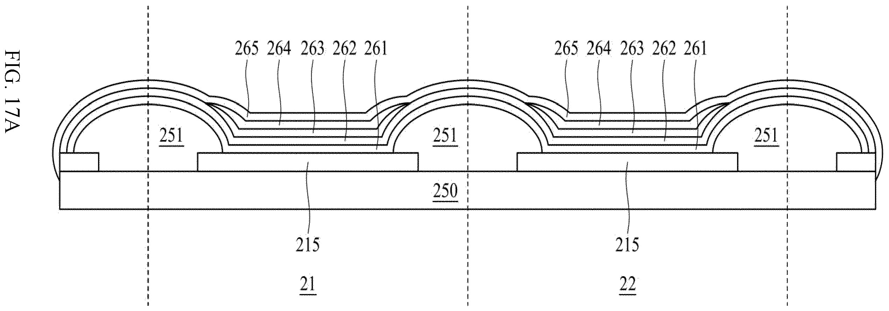

The operations shown in FIGS. 16A-16G may be repeatedly performed to form light-emitting units of different colors. FIG. 17A illustrates another light-emitting unit that emits a second color different from the first color. The second electrodes 265 of the first light-emitting unit 21 and the second light-emitting unit 22 are continuous. Each light-emitting unit has an independent carrier transport layer 264. The independent carrier transport layer 264 is segmented into a plurality of segments, and each segment is disposed on a light-emitting unit. In some embodiments, a plurality of light-emitting units shares a common carrier transport layer 264.

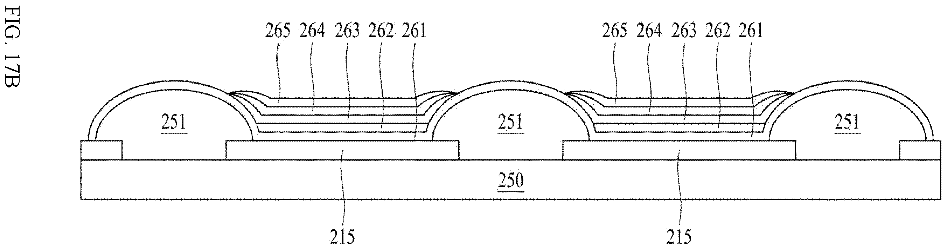

As shown in FIG. 17B, in some embodiments, each light-emitting unit has an independent carrier transport layer 262 (closer to the first electrode 215 than the carrier transport layer 264). The carrier transport layer 262 is segmented into a plurality of segments, and each segment is disposed on a light-emitting unit. In some embodiments, a plurality of light-emitting units shares a common carrier transport layer 262. Each light-emitting unit has an independent carrier injection layer 261. The independent carrier injection layer 261 is segmented into a plurality of segments, and each segment is disposed on a light-emitting unit. In some embodiments, a plurality of light-emitting units shares a common carrier injection layer 261.

In some embodiments, the second carrier transport layer 264 has at least two secondary layers. The first secondary layer is between the second secondary layer and the EM layer 264. In some embodiments, the second secondary layer is between the first secondary layer and the second electrode 265. In some embodiments, both the secondary layers are continuous, and the light-emitting units 21 and 22 use a common first secondary layer and a common second secondary layer. In some embodiments, one secondary layer is segmented and the other secondary layer is continuous. In some embodiments, the first secondary layer is continuous and the second secondary layer is segmented. Each light-emitting unit has an independent second secondary layer. In some embodiments, the second secondary layer is continuous and the first secondary layer is segmented. Each light-emitting unit has an independent first secondary layer.

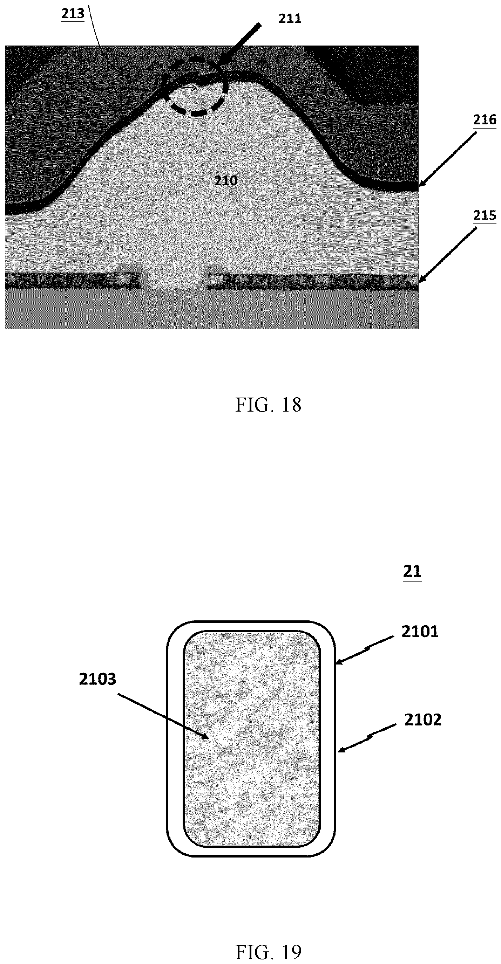

FIG. 18 depicts an implementation aspect of the bump 210. The bump 210 includes a surface facing away from the substrate, and the surface includes a corrugated portion 211, which includes a vertex 213 facing the substrate 100 or the first electrode 215. The formation of the vertices 213 can be accomplished by adjusting the thermal expansion coefficient of the laminated layers, by the developing processes, and by controlling the formation of the bumps 210 and the formation parameters of the second electrodes 216, thereby forming the corrugated portion 211 and further forming the vertex 213 facing toward the substrate 100 or the first electrode 215. The existence of the corrugated portion 211 and the vertex 213 can increase the adhesion between the second electrode 216 and the surface of the bump 210, thereby preventing the second electrode 216 from being peeled off from the bumps 210 due to the stress generated during subsequent processes.

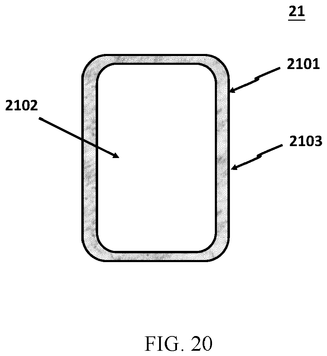

FIG. 19 is a top view of an embodiment of an organic light-emitting unit 21. The light-emitting unit 21 has an effective light-emitting region 2101, whose size is equal to the total area of a first electrode 213 located under each light-emitting unit. Each light-emitting unit has a black region 2103 located inside the effective light-emitting region 2101 when emitting light, and an annular bright region 2102 surrounding the black region 2103, wherein the total area of the black region 2103 is less than 50% of the effective light-emitting region. FIG. 20 shows another embodiment. The annular black region 2103 is located outside the effective light-emitting region 2101 and surrounds the bright region 2102.

The determination of the black regions and the bright regions can be done with the help of a microscope, and the comparison of brightness can be measured and compared by those skilled in the art. In one embodiment, the total area of the black region 2103 is less than 45% of the effective light-emitting region. In one embodiment, the total area of the black region 2103 is less than 40% of the effective light-emitting region. In one embodiment, the total area of the black region 2103 is less than 35% of the effective light-emitting region. In one embodiment, the total area of the black region 2103 is less than 30% of the effective light-emitting region. In one embodiment, the total area of the black region 2103 is less than 25% of the effective light-emitting region. In one embodiment, the total area of the black region 2103 is less than 20% of the effective light-emitting region. In one embodiment, the total area of the black region 2103 is less than 15% of the effective light-emitting region. In one embodiment, the total area of the black region 2103 is less than 10% of the effective light-emitting region. In one embodiment, the total area of the black region 2103 is less than 5% of the effective light-emitting region.

The foregoing summarizes the features of some implementations so that those skilled in the art may better understand various aspects of the present disclosure. Those skilled in the art should understand that the present disclosure can be readily used as a basis to design or modify other processes and structures to achieve the same purposes and/or obtain the same advantages as the embodiments described in this application. Those skilled in the art should also understand that such equivalent configuration does not depart from the spirit and scope of the disclosure, and they can make various changes, substitutions and alterations thereto without departing from the spirit and scope of the disclosure.

## Claims

1. A light-emitting device, comprising:
a substrate;
a capping layer;
a plurality of bumps disposed over the substrate and between the substrate and the capping layer, wherein the plurality of bumps include two adjacent bumps, and an organic light-emitting unit including an organic material is disposed between the two adjacent bumps;
wherein at least one of the plurality of bumps includes a surface facing away from the substrate, the surface includes a corrugated portion, which includes a vertex facing the substrate;
an optical absorption unit disposed between the substrate and the capping layer.

2. A light-emitting device, comprising:
a substrate;
a plurality of organic light-emitting units above the substrate, wherein the plurality of organic light-emitting units includes a first light-emitting unit and a second light-emitting unit, wherein the first light-emitting unit and the second light-emitting unit each has an organic light-emitting stack layer including an organic material and emits light with different color, wherein a total thickness of the organic light-emitting stack layer of the first light-emitting unit is greater than a total thickness of the organic light-emitting stack layer of the second light-emitting unit.

3. A method of manufacturing a light-emitting device, comprising:
providing a substrate;
forming a plurality of bumps on the substrate;
forming a photosensitive layer on the plurality of bumps;
patterning the photosensitive layer to form a trench through the photosensitive layer to expose a surface;
disposing an organic material on the surface;
removing the patterned photosensitive layer; and
continuously disposing a dielectric layer over the plurality of bumps, wherein at least one bump among the plurality of bumps includes a surface facing away from the substrate, the surface includes a corrugated portion, and the corrugated portion includes a vertex facing the substrate.

4. The light-emitting device of any one of claims 1 to 3, wherein an absorption rate of the bump for a specific wavelength is greater than or equal to 60% and the specific wavelength is not greater than 400 nm.

5. The light-emitting device of claim 1, wherein the capping layer includes a material, an absorption rate of the material for a specific wavelength is greater than or equal to 60%, and the specific wavelength is not greater than 400 nm.

6. The light-emitting device of any one of claims 1 to 2, wherein an absorption rate of the organic material for a specific wavelength is greater than or equal to 60% and the specific wavelength is not greater than 400 nm.

7. The light-emitting device of claim 3, wherein an absorption rate of the photosensitive layer for a specific wavelength is greater than or equal to 30% and the specific wavelength is not greater than 400 nm.

8. The light-emitting device of any one of claims 1 to 3, wherein the organic material is disposed in an organic layer, and the organic layer is one of an electron transport layer (ETL), an electron injection layer (EIL), an emissive layer (EM), a hole blocking layer (HBL), a hole injection layer (HIL), or a hole transport layer (HTL).

9. The light-emitting device of claim 1, wherein an absorption rate of the optical absorption unit for a specific wavelength is greater than or equal to 60% and the specific wavelength is not greater than 400 nm.

10. The organic light-emitting device of any one of claims 1 to 2, wherein each of the organic light-emitting units has an effective light-emitting region with a size equal to a total area of an anode located under each of the light-emitting units, and each of the light-emitting units has a black region and a bright region when emitting light, wherein a total area of the black region is less than 50% of the effective light-emitting region.
